# EUROPEAN PATENT APPLICATION

(11) **EP 4 845 365 A1**
(43) Date of publication of application: **25.11.2026**
(21) Application number: 26180585.7
(22) Date of filing: 22.05.2026
(51) Int. Cl.: H10K 59/121

(54) **PIXEL CIRCUIT AND DISPLAY PANEL INCLUDING THE SAME**

(30) Priority: 23.05.2025 KR 20250067384
(71) Applicant: LG Display Co., Ltd., Seoul 07336 (KR)
(72) Inventor: JUNG, Do Young, 10845 Paju-si (KR); PARK, Yong Chan, 10845 Paju-si (KR)
(74) Representative: Ter Meer und Partner mbB

(57) **Abstract**

A display panel according to one embodiment of the present specification includes a first display region including a first pixel region and a light-transmitting region, wherein the first pixel region and the light-transmitting region share a capacitor.

## Description

This application claims priority to and the benefit of Korean Patent Application No. 10-2025-0067384, filed on May 23, 2025.

### BACKGROUND

### 1. Field of the Invention

The present specification relates to a display panel, and more particularly, to a display panel capable of implementing a full-screen display with improved luminance of an imaging region in display mode.

### 2. Discussion of Related Art

As the information society develops, the demand for display devices for displaying images is increasing in various forms, and recently, various display devices such as liquid crystal display devices (LCDs), plasma display panels (PDPs), and organic light-emitting display devices (OLEDs) have been utilized.

Recently, the multimedia functions of electronic devices such as mobile terminals have been improving. For example, sensors or devices that receive external light, such as cameras, are built into mobile terminals by default. However, a front camera of a mobile terminal limits screen design, thereby making screen design difficult. Although screen designs including a notch or a punch hole have been adopted for mobile terminals to reduce the space occupied by the camera, the screen size is still limited by the camera, thereby making it difficult to implement a full-screen display.

In order to implement a full screen display, a method of providing an imaging region in which pixels are disposed in the screen of a display panel and arranging a camera and/or various sensors in the imaging region is proposed. The imaging region disposed in the screen may include a transmitting portion through which external light is introduced into the camera and/or various sensors. However, the imaging region has a problem that the density of pixels per unit area is lower than that of the periphery of the imaging region, resulting in decreased luminance.

### SUMMARY OF THE INVENTION

The present specification is directed to provide a display panel capable of implementing a full-screen display with improved resolution and/or luminance of an imaging region in display mode.

The object is solved by the features of the independent claim. The objects to be achieved in the present specification are not limited to those described above, and other objects that are not described will be clearly understood by those skilled in the art to which the technical idea of the present specification pertains from the description below.

According to an aspect of the present invention, a display panel includes a first display region including a first pixel region and a light-transmitting region, wherein the first pixel region and the light-transmitting region share a capacitor.

According to an aspect of the present invention, a pixel circuit includes a driving transistor including a first electrode connected to a first node, a gate electrode connected to a second node, and a second electrode connected to a third node; a driving voltage node to which a pixel driving voltage is applied; a first capacitor connected between the driving voltage node and the third node; and a second capacitor connected to the first capacitor.

According to an aspect of the present invention, a display panel includes a pixel circuit according to any one of the herein described aspects and embodiments; a first pixel region and a light-transmitting region; and a first pixel in which the pixel circuit is disposed, wherein the second capacitor is disposed in the light-transmitting region.

According to an aspect of the present invention, a display panel includes a pixel circuit according to any one of the herein described aspects and embodiments; a first pixel region and a light-transmitting region; and a first pixel in which a pixel circuit is disposed. The pixel circuit comprises a driving transistor including a first electrode connected to a first node, a gate electrode connected to a second node, and a second electrode connected to a third node; a driving voltage node to which a pixel driving voltage is applied; a first capacitor connected between the driving voltage node and the third node; and a second capacitor connected to the first capacitor; wherein the second capacitor is disposed in the light-transmitting region.

### BRIEF DESCRIPTION OF THE DRAWINGS

The above and other objects, features and advantages of the present invention will become more apparent to those of ordinary skill in the art by describing exemplary embodiments thereof in detail with reference to the accompanying drawings, in which:
FIG. 1 is a conceptual view of a display device according to one embodiment of the present specification;
FIG. 2 is a block diagram showing a display device with the display panel and a display panel driving unit according to one embodiment of the present specification;
FIG. 3 is a cross-sectional view schematically showing the display panel according to one embodiment of the present specification;
FIG. 4 is a circuit diagram showing a pixel circuit disposed in a second pixel region of the second display region according to one embodiment of the present specification;
FIG. 5 is a waveform diagram for the pixel circuit shown in FIG. 4;
FIG. 6 is a luminance graph for a conventional pixel circuit and the pixel circuit shown in FIG. 4;
FIG. 7 is a plan view showing a first display region and a second display region according to one embodiment of the present specification;
FIG. 8 is an enlarged view of a first pixel and a second pixel of FIG. 7;
FIGS. 9A to 9C are plan views of a display panel according to a first embodiment of the present specification;
FIG. 10 shows cross-sectional views along lines I-I' and II-II' of FIG. 9A;
FIG. 11 is a plan view of a display panel according to a second embodiment of the present specification;
FIG. 12 shows cross-sectional views along lines I-I' and III-III' of FIG. 11;
FIG. 13 is a plan view of a display panel according to a third embodiment of the present specification;
FIG. 14 shows cross-sectional views along lines IV-IV' and V-V' of FIG. 13;
FIG. 15 is a cross-sectional view of a display panel according to a fourth embodiment of the present specification;
FIG. 16 is a cross-sectional view of a display panel according to a fifth embodiment of the present specification;
FIG. 17 is a cross-sectional view for first to third subpixels included in a second pixel according to a sixth embodiment of the present specification; and
FIG. 18 is a cross-sectional view for first to third subpixels included in a second pixel according to a seventh embodiment of the present specification.

### DETAILED DESCRIPTION OF EXEMPLARY EMBODIMENTS

Advantages and features of the present specification and methods of achieving them will become apparent with reference to the following embodiments, which are described in detail, in conjunction with the accompanying drawings. The present specification, however, is not limited thereto to the embodiments disclosed hereinafter, but will be practiced in many different forms, and these embodiments are provided merely to make the disclosure of the present specification complete and to make the scope of the specification fully apparent to one of ordinary skill in the art to which the present specification belongs, the scope of the present specification being defined by the claims and the equivalent thereof.

The shapes, sizes, proportions, angles, numbers, etc., disclosed in the drawings to illustrate embodiments of the present specification are exemplary and are not limited thereto. In addition, in describing the present specification, detailed descriptions of relevant known technology are omitted if it is determined that such detailed descriptions would unnecessarily obscure the essence of the present specification.

When 'including,' 'having,' 'consisting of,' and the like mentioned in the present specification are used, other parts may be added unless 'only' is used. A case in which a component is expressed in a singular form includes a plural form unless explicitly stated otherwise.

In interpreting a component, the component is interpreted as including the margin of error even when there is no separate explicit description.

In the case that a positional relationship is described, when the positional relationship of two parts is described such as "upon," "above," "under," or "beside," unless "right" or "directly" is used, one or more other parts may be located between the two parts.

A case where an element or a layer is described as being on another element or layer includes both cases in which the element or layer is directly on the other element or layer and cases in which still another layer or element is interposed between the element or layer and the other element or layer.

Although first, second, and the like are used to describe various components, these components are not limited by these terms. These terms are only used to distinguish one component from another. Accordingly, a first component mentioned below may also be a second component within the technical spirit of the present disclosure.

Throughout the specification, the same reference numerals refer to the same components.

The size and thickness of each component shown in the drawings are shown for convenience of description and are not necessarily limited to sizes and thicknesses of the components shown in the present specification.

Features of various embodiments of the present specification may be partially or entirely combined with each other, and technically, various linkages and operations are possible, and the embodiments may be implemented independently of each other or together in a related relationship.

In the present specification, a "device" may include a display device such as a liquid crystal module (LCM), an organic light-emitting display device (OLED Module), including a display panel and a driving unit for driving the display panel. It may also include a complete product or final product including LCMs, OLED modules, and the like, such as a laptop computer, a television, a computer monitor; an equipment apparatus including an automotive apparatus or other form of vehicle; and a set electronic apparatus or set device, for example, a mobile electronic apparatus, such as a smartphone or an electronic pad, and the like.

A display device in the present specification may therefore include a display device itself, such as an LCM, OLED module, and the like, and a set device, which is an application or end-consumer device that includes an LCM, OLED module, and the like.

And, in some embodiments, an LCM, OLED module comprising a display panel, a driving unit, and the like may be expressed as a "display device" and an electronic device as a finished product including the LCM, OLED module may be distinguished and expressed as a "set device." For example, the display device may include a liquid crystal (LCD) or organic light-emitting (OLED) display panel, and a source PCB that is a control portion for driving the display panel. The set device may further comprise a set PCB, which is a set control unit electrically connected to the source PCB to drive the entire set device.

The display panel used in the embodiments of the present specification may include any type of display panel, such as a liquid crystal display panel, an organic light-emitting diode (OLED) display panel, and an electroluminescent display panel. However, the present specification is not limited thereto.

Hereinafter, various embodiments of the present invention will be described in detail with reference to the accompanying drawings. The components shown in the FIGS are drawn to scale for convenience of illustration and are not limited thereto.

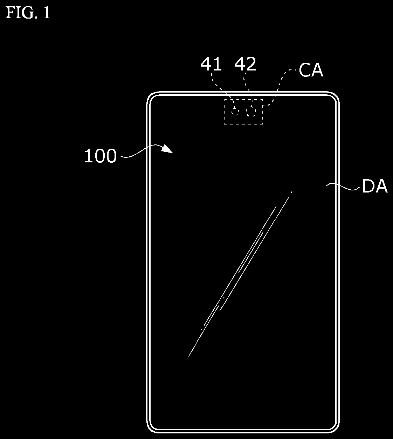

FIG. 1 is a conceptual view of a display panel according to one embodiment of the present specification.

Referring to FIG. 1, a display device according to one embodiment the present specification may include a display panel 100 and a case, and the front surface of the display panel 100 may be formed as a display region. Therefore, full-screen display may become possible.

The display region may include a first display region DA and a second display region CA. Although both the first display region DA and the second display region CA output images, their resolutions may differ. For example, the resolution of a plurality of second pixels disposed in the second display region CA may be lower than the resolution of a plurality of first pixels disposed in the first display region DA. However, the present specification is not necessarily limited thereto, and the resolution of the first display region DA and the resolution of the second display region CA may be substantially the same.

The first display region DA and the second display region CA may have different light transmittances per unit area. According to one embodiment, the second display region CA may further include a light-transmitting region compared to the first display region DA. Although the display panel according to one embodiment includes a light-transmitting region in the second display region CA, the luminances of the first and second display regions DA and CA may be substantially similar.

The display panel according to one embodiment may undergo various design changes to achieve the same level(s) of resolution and/or luminance in the first and second display regions DA and CA. For example, as the resolution of the plurality of second pixels disposed in the second display region CA decreases, a sufficient amount of light may be injected into sensors or electronic devices 41 and 42 disposed in the second display region CA. As another example, when the second display region CA operates in a display mode in which an image is displayed, the light-transmitting region may include a light-emitting region so that a sufficient amount of light is emitted to the second display region CA.

The second display region CA may be a region in which at least one electronic device 41 or 42 is disposed. Since the second display region CA is a region that overlaps various electronic devices, the second display region CA may have a smaller area than the first display region DA, which outputs most of the image.

The electronic devices 41 and 42 may include at least one of an image sensor, an infrared sensor, a proximity sensor, a light sensor, a gesture sensor, a motion sensor, a fingerprint sensor, and a biometric sensor. For example, the first electronic device 41 may be a light sensor and the second electronic device 42 may be an image sensor that captures an image or video, but the present specification is not limited thereto.

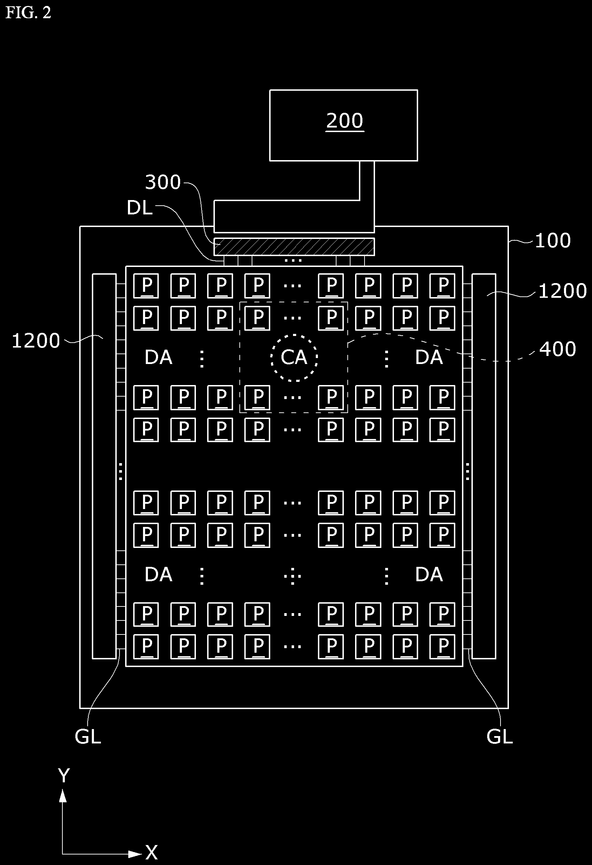

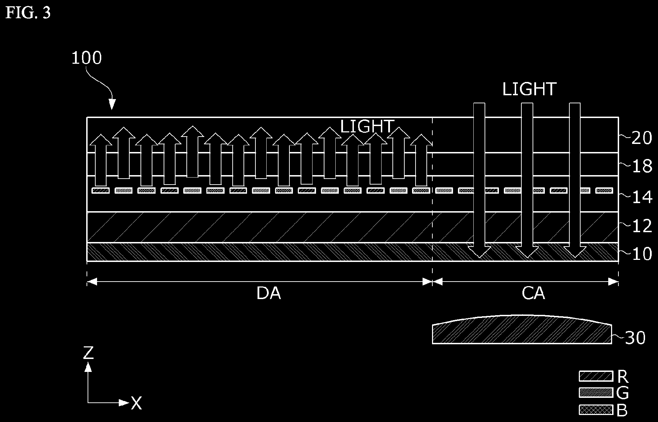

FIG. 2 is a block diagram showing a display device with the display panel and a display panel driving unit according to one embodiment of the present specification. FIG. 3 is a cross-sectional view schematically showing the display panel according to one embodiment of the present specification.

Referring to FIGS. 2 and 3, a horizontal direction X and a vertical direction Y of the display panel 100 may be a longitudinal direction and a width direction of the display panel 100, respectively. Additionally, the horizontal direction X and the vertical direction Y of the display panel 100 may be represented as a row direction and a column direction, respectively. A thickness direction Z may be a direction perpendicular to a plane having the horizontal direction X and the vertical direction Y of the display panel 100. Further, the display panel 100 may have a cross-section in the thickness direction Z.

Referring to FIG. 2, the display device may include the display panel 100 having a screen on which a pixel array is disposed, a display panel driving unit, etc.

The pixel array of the display panel 100 may include data lines DL, gate lines GL intersecting the data lines DL, and pixels P arranged in a matrix form defined by the data lines DL and the gate lines GL. The pixel array may further include various power wirings.

The pixel array may be divided into a circuit layer 12 and a light-emitting element layer 14 as shown in FIG. 3. A touch sensor array may be disposed above the light-emitting element layer 14. Each pixel in the pixel array may include two to four subpixels. Each of the subpixels may include a pixel circuit disposed in the circuit layer 12.

The screen on which an input image is reproduced on the display panel 100 may include the first display region DA and the second display region CA.

Each of the subpixels of the first display region DA and the second display region CA may include a pixel circuit. The pixel circuit may include a driving element that supplies a current to a light-emitting element (organic light-emitting display device (OLED)), a plurality of switch elements that sample the threshold voltage of the driving element and switch the current path of the pixel circuit, a capacitor that maintains the gate voltage of the driving element, etc. The pixel circuit may be disposed under the light-emitting element.

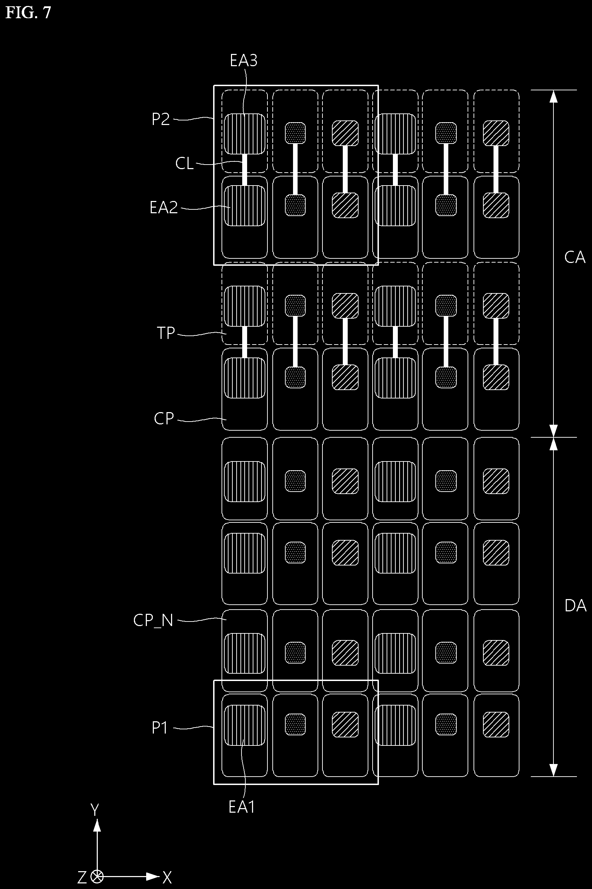

The second display region CA may include a light-transmitting region (TP of FIG. 7) disposed between pixel groups and a camera module 400 disposed below the second display region CA. The camera module 400 may photoelectrically convert light incident through the second display region CA using the image sensor in capturing mode and convert pixel data of an image output from the image sensor into digital data to output captured image data.

The display panel driving unit may write pixel data of the input image to the pixels P. The pixels P may be interpreted as a pixel group including a plurality of subpixels.

The display panel driving unit may include a data driving unit that supplies a data voltage of pixel data to the data lines DL and a gate driving unit 1200 that sequentially supplies a gate pulse to the gate lines GL. The data driving unit can be integrated into a driver integrated circuit (IC) 300. The display panel driving unit may further include a touch sensor driving unit.

The driver IC 300 may be bonded onto the display panel 100. The driver IC 300 may receive pixel data and a timing signal of the input image from a host system 200, supply the data voltage of the pixel data to the pixels, and synchronize the data driving unit and a gate driving unit 1200.

The driver IC 300 may be connected to the host system 200 and the display panel 100. The driver IC 300 may include a timing controller, a data driving unit, a power supply unit, a data receiving and calculating unit, a gamma compensation voltage generation unit, a memory, etc.

The timing controller may provide the pixel data of the input image received from the host system 200 to the data driving unit. The timing controller may control an operation timing of the gate driving unit 1200 and the data driving unit by generating a gate timing signal for controlling the gate driving unit 1200 and a source timing signal for controlling the data driving unit.

The data driving unit may convert digital data, including the pixel data received from the timing controller, into a gamma compensation voltage through a digital-to-analog converter (DAC) and output a data voltage. The data voltage output from the data driving unit may be supplied to the data lines DL of the pixel array through an output buffer connected to a data channel of the driver IC 300.

The power supply unit may generate power required to drive the pixel array of the display panel 100, the gate driving unit 1200, and the driver IC 300 using a direct current (DC)-DC converter.

The power supply unit may generate DC power such as a gamma reference voltage, a gate-on voltage VGL, a gate-off voltage VGH, a pixel driving voltage (VDD), a low-potential power voltage (VSS), and an initialization voltage (Vini) by adjusting a DC input voltage from the host system 200.

The host system 200 may be implemented as an application processor (AP). The host system 200 may transmit the pixel data of the input image to the driver IC 300 through a mobile industry processor interface (MIPI). The host system 200 may be connected to the driver IC 300 through, for example, a flexible printed circuit (FPC).

The driver IC 300 may be connected to the data lines DL through data output channels and may supply the data voltage of the pixel data to the data lines DL. The driver IC 300 may output a gate timing signal for controlling the gate driving unit 1200 through gate timing signal output channels.

A gate timing signal generated from the timing controller may include a start pulse (VST, gate start pulse), a shift clock (CLK, gate shift clock), etc. The start pulse (VST) and the shift clock (CLK) may swing between the gate-on voltage (VGH or VGL) and the gate-off voltage (VGH or VGL).

The gate driving unit 1200 may include a shift register formed in the circuit layer of the display panel 100 together with the pixel array. The shift register of the gate driving unit 1200 may sequentially supply gate signals to the gate lines GL under the control of the timing controller. The gate signal may include a light-emission (EM) pulse of a light-emission signal and a scan pulse. The shift register may include a scan driving unit that outputs a scan pulse and an EM driving unit that outputs an EM pulse.

The display panel 100 may be implemented as a flexible panel applicable to a flexible display. The flexible display may be easily manufactured in various designs and have variable screen sizes by rolling, folding, or bending the flexible panel.

The flexible display may be implemented as a rollable display, a foldable display, a bendable display, a slidable display, etc.

In the display device of the present invention, the pixel circuit, the gate driving unit, and the like disposed in the circuit layer 12 may include a plurality of transistors. The transistors may be implemented as an oxide thin film transistor (TFT) including an oxide semiconductor, a low-temperature poly silicon transistor (LTPS TFT) including low-temperature poly silicon (LTPS), etc. Each of the transistors may be implemented as a p-channel TFT or an n-channel TFT. In the embodiment, a case in which the transistors of the pixel circuit are implemented as p-channel TFTs is described as an example, but the present invention is not limited thereto.

The gate pulse may swing between the gate-on voltage and the gate-off voltage. The gate-on voltage may be set to a voltage higher than a threshold voltage of the transistor, and the gate-off voltage may be set to a voltage lower than the threshold voltage of the transistor.

The transistor may be turned on in response to the gate-on voltage, while the transistor may be turned off in response to the gate-off voltage. In the case of an n-channel transistor, the gate-on voltage may be a gate high voltage VGH, and the gate-off voltage may be a gate low voltage VGL. In the case of a p-channel transistor, the gate-on voltage may be a gate low voltage VGL, and the gate-off voltage may be a gate high voltage VGH.

A driving element of the pixel circuit may be implemented as a transistor. Although the driving element needs to have uniform electrical characteristics across all pixels, due to process variations and element characteristic variations, there may be differences in electrical characteristics among the pixels, and the electrical characteristics may change as the display driving time elapses. To compensate for these variations in electrical characteristics of the driving element, the display panel may include an internal compensation circuit and an external compensation circuit.

Referring to FIG. 3, the first display region DA and the second display region CAmay include a pixel array in which pixels to which pixel data is written are disposed. The number of pixels per unit area (pixels per inch (PPI)) of the second display region CA may be lower than the PPI of the first display region DA to secure the light transmittance of the second display region CA. However, the present specification is not necessarily limited thereto, and the PPI s of the first display region DA and the second display region CA may be formed identically or similarly.

In the second display region CA, external light may pass through the display panel 100 through a light-transmitting region with high light transmittance and may be received by a sensor below the display panel 100.

Since both the first display region DA and the second display region CA include pixels, an input image may be reproduced on the first display region DA and the second display region CA.

Each of the pixels P of the first display region DA and the second display region CA may include subpixels with different colors to implement the color of the image. For example, the subpixels may include red subpixels, green subpixels, and blue subpixels, but the present specification is not limited thereto. Each of the subpixels disposed in the pixel region may include a pixel circuit and a light-emitting element.

The second display region CA may include pixels and a camera module 400 disposed below the screen of the display panel 100. The pixels in the second display region CA may display an input image when the pixel data of the input image is written to the pixels in display mode.

The camera module 400 may capture an external image in a capturing mode and output image or video image data. A lens 30 of the camera module 400 may be disposed to correspond to the second display region CA. For example, the lens 30 of the camera module 400 may face the second display region CA.

External light is incident on a lens 30 of the camera module 400 through the second display region CA, and the lens 30 may concentrate light on the image sensor that is omitted in the drawing. The camera module may capture an external image in a capturing mode and output image or video image data.

The display panel 100 may include the circuit layer 12 disposed on a substrate 10 and the light-emitting element layer 14 disposed on the circuit layer 12. A polarizer 18 may be disposed on the light-emitting element layer 14, and a cover glass 20 may be disposed on the polarizer 18.

The circuit layer 12 may include the pixel circuit connected to wirings such as data lines, gate lines, and power lines, the gate driving unit connected to the gate lines, etc.

The circuit layer 12 may include circuit elements such as a transistor implemented as a thin film transistor (TFT) and a capacitor. The wirings and the circuit elements of the circuit layer 12 may be implemented with a plurality of insulating layers, two or more metal layers separated from each other with an insulating layer interposed therebetween, and an active layer including a semiconductor material.

The light-emitting element layer 14 may include a light-emitting element driven by the pixel circuit. The light-emitting element may be implemented as an OLED. The OLED may include an organic compound layer formed between an anode electrode and a cathode electrode.

The light-emitting element layer 14 may be disposed on pixels that selectively transmit red, green, and blue wavelengths, and may further include a color filter array. The light-emitting element layer 14 may be covered by a protective film, and the protective film may be covered by an encapsulation layer.

The polarizer 18 may be bonded onto the encapsulation layer. The polarizer 18 may improve the external visibility of the display device. The polarizer 18 may be implemented as a polarizer in which a linear polarizer and a phase retardation film are bonded, or a circular polarizer.

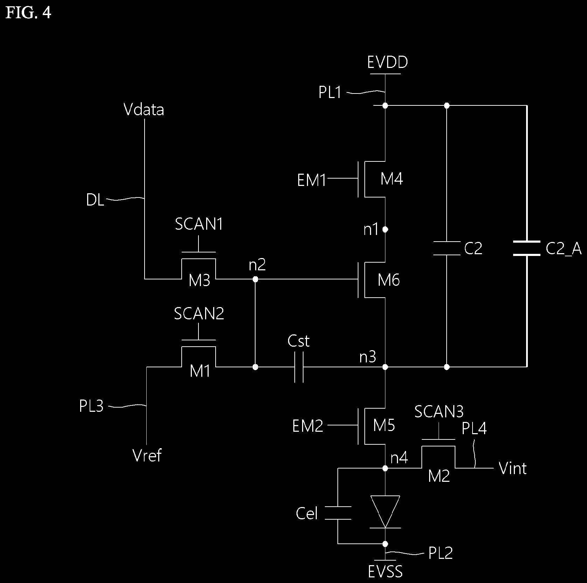

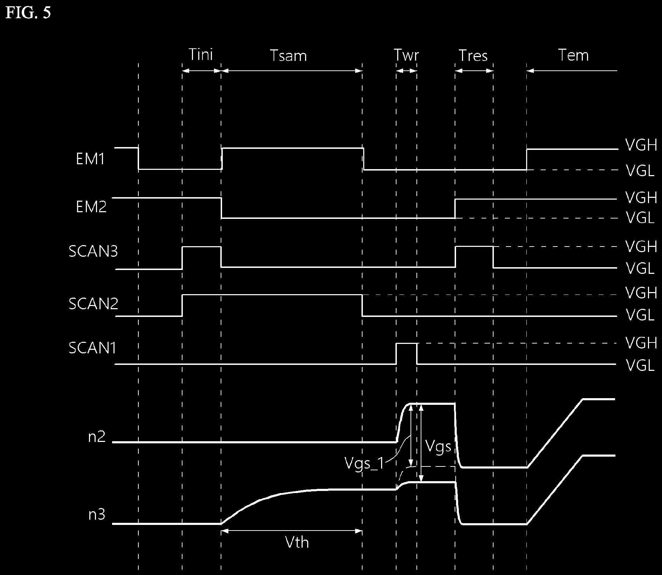

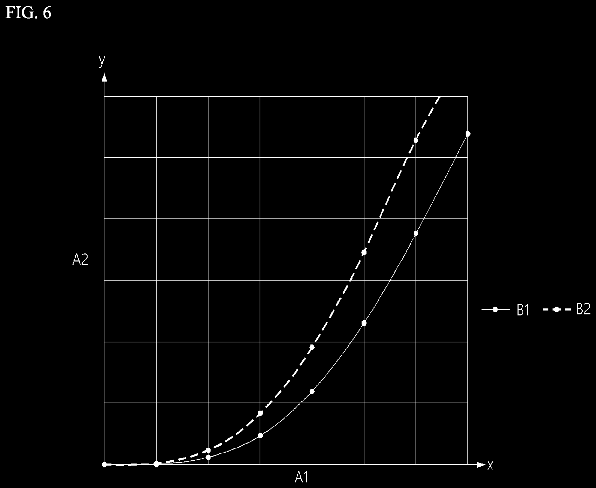

FIG. 4 is a circuit diagram showing a pixel circuit disposed in a second pixel region CP of the second display region according to one embodiment of the present specification. FIG. 5 is a waveform diagram for the pixel circuit shown in FIG. 4. FIG. 6 is a luminance graph for a conventional pixel circuit and the pixel circuit according to the display panel of the present specification. Meanwhile, a pixel circuit formed in a first pixel region CP_N of the first display region DA may be formed in the same manner as a pixel circuit of the second pixel region CP except for a second capacitor C2_A, but the present specification is not limited thereto.

Referring to FIGS. 4 and 5, the pixel circuit may include a driving transistor M6, a plurality of switch transistors M1, M2, M3, M4, and M5, a first capacitor C2, the second capacitor C2_A, and a third capacitor Cst. The transistors M1 to M6 of the pixel circuit may be implemented as n-channel oxide TFTs but are not limited thereto.

The pixel circuit may be connected to a data line DL to which a data voltage Vdata of pixel data is applied, and gate lines to which gate signals SCAN1, SCAN2, SCAN3, EM1, and EM2 are applied. The pixel circuit may be connected to a first driving voltage node PL1 to which a pixel driving voltage EVDD is applied, a second driving voltage node PL2 to which a pixel ground voltage EVSS is applied, a third driving voltage node PL3 to which a reference voltage Vref is applied, and a fourth driving voltage node PL4 to which an anode reset voltage Vint is applied. The driving voltage nodes may be connected to corresponding power lines.

A voltage level of each of the driving voltages EVDD, EVSS, Vref, and Vint applied to the pixel circuit may be set by considering the voltage margin for saturation region operation. The voltage levels of the driving voltages EVDD, EVSS, Vref, and Vint may be set under the condition in which EVDD>Vref>Vint>EVSS is satisfied. For example, the pixel driving voltage EVDD may be a voltage between 7 [V] and 10 [V], the reference voltage Vref may be a voltage between 1 [V] and 2 [V], the anode reset voltage Vint may be a voltage between -2 [V] and -4 [V], and the pixel ground voltage EVSS may be a voltage between -5 [V] and -7 [V], but are not limited thereto.

The data voltage Vdata output from the gate driving unit 1200 may have a dynamic range set between the reference voltage Vref and the pixel driving voltage EVDD. For example, the minimum voltage of the data voltage Vdata may be set to a voltage close to the reference voltage Vref, and the maximum voltage of the data voltage Vdata may be set to a voltage close to the pixel driving voltage EVDD. The data voltage Vdata may be selected according to pixel data within a dynamic range of 3 [V] to 5 [V] but is not limited thereto.

A gate high voltage VGH may be set to a voltage higher than the pixel driving voltage EVDD, and a gate low voltage VGL may be set to a voltage lower than the pixel ground voltage EVSS. For example, the gate high voltage VGH may be a voltage between 11 [V] and 12 [V], and the gate low voltage VGL may be a voltage between -8 [V] and -10 [V], but are not limited thereto. Hereinafter, the gate high voltage VGH may be referred to as a gate-on voltage, and the gate low voltage VGL may be referred to as a gate-off voltage.

The gate signals SCAN1, SCAN2, SCAN3, EM1, and EM2 may include pulses that swing between the gate-on voltage VGH and the gate-off voltage VGL.

The pixel circuit shown in FIG. 4 may be driven in the order of an initialization period Tini, a sensing period Tsam, a data writing period Twr, an anode reset period Tres, and an emission period Tem during one frame period, as shown in FIG. 5. The initialization period Tini, the sensing period Tsam, the data writing period Twr, the anode reset period Tres, and the emission period Tem may be defined by the waveforms of the gate signals SCAN1, SCAN2, SCAN3, EM1, and EM2.

A voltage of a first EM signal EM1 may be a gate-on voltage VGH during the sensing period Tsam and the emission period Tem, and a gate-off voltage VGL during the initialization period Tini, the data writing period Twr, and the anode reset period Tres. A fourth switch transistor M4 may be turned on in response to the gate-on voltage VGH of the first EM signal EM1 and may be turned off in response to the gate-off voltage VGL of the first EM signal EM1.

A voltage of a second EM signal EM2 may be a gate-on voltage VGH during the initialization period Tini, the anode reset period Tres, and the emission period Tem, and a gate-off voltage VGL during the sensing period Tsam and the data writing period Twr. A fifth switch transistor M5 may be turned on in response to the gate-on voltage VGH of the second EM signal EM2 and may be turned off in response to the gate-off voltage VGL of the second EM signal EM2.

A voltage of the first scan signal SCAN1 may be generated as a pulse of the gate-on voltage VGH synchronized with the data voltage Vdata of the pixel data during the data writing period Twr, and may be a gate-off voltage VGL during the other periods Tini, Tsam, Tres, and Tem. A third switch transistor M3 may be turned on in response to the gate-on voltage VGH of the first scan signal SCAN 1 and may be turned off in response to a gate-off voltage VGL of the first scan signal SCAN1.

A voltage of the second scan signal SCAN2 may be generated as a pulse of the gate-on voltage VGH during the initialization period Tini and the sensing period Tsam, and may be a gate-off voltage VGL during the other periods Twr, Tres, and Tem. A first switch transistor M1 may be turned on in response to the gate-on voltage VGH of the second scan signal SCAN2 and may be turned off in response to the gate-off voltage VGL of the second scan signal SCAN2.

A voltage of the third scan signal SCAN3 may be a gate-on voltage VGH during the initialization period Tini and the anode reset period Tres, and a gate-off voltage VGL during the sensing period Tsam, the data writing period Twr, and the emission period Tem. The second switch transistor M2 may be turned on in response to the gate-on voltage VGH of the third scan signal SCAN3 and may be turned off in response to the gate-off voltage VGL of the third scan signal SCAN3.

The driving transistor M6 may generate a current according to a gate-source voltage Vgs to drive a light-emitting element. The gate-source voltage Vgs of the driving transistor M6 may be a voltage applied between a second node n2 and a third node n3. The driving transistor M6 may include a first electrode connected to a first node n1, a gate electrode connected to the second node n2, and a second electrode connected to the third node n3.

An anode electrode of the light-emitting element EL may be connected to a fourth node n4, and a cathode electrode may be connected to the second driving voltage node PL2 to which the pixel ground voltage EVSS is applied. The light-emitting element EL may include a fourth capacitor Cel formed between the anode electrode and the cathode electrode.

The first capacitor C2 and the second capacitor C2_A may be formed in a shared form. The shared form may include all of the various types as follows. It may mean that the first capacitor C2 and the second capacitor C2_A are integrally formed. Additionally, the first capacitor C2 and the second capacitor C2_A may be each formed, which may mean that the two capacitors (C2 and C2_A) are electrically connected through a node. When the first capacitor C2 and the second capacitor C2_A are integrally formed, it may mean that the first capacitor C2 and second capacitor C2_A are integrally formed over the second pixel region and the light-transmitting region.

The first capacitor C2 may be connected between the first driving voltage node PL1 and the third node n3. The pixel driving voltage EVDD may be applied to the first driving voltage node PL1. The second capacitor C2-A may prevent loss of the data voltage Vdata.

The second capacitor C2_A may be formed in a form shared with the first capacitor C2. For example, the second capacitor C2_A may be electrically connected in parallel with the first capacitor C2.

The display panel of the present specification according to one embodiment may more effectively prevent loss of the data voltage Vdata by including the second capacitor C2_A. The first and second capacitors C2 and C2_A may affect the gate-source voltage Vgs of the data voltage Vdata according to the following Equation 1. Here, C2 and C2_A in the Equation 1 are capacitance values of the first and second capacitors C2 and C2_A, respectively. [Equation 1] ${V}_{gs} = \frac{C 2 + C 2 _ A}{Cst + C 2 + C 2 _ A} \left({V}_{data}-{V}_{ref}\right) + {V}_{th}$

The third capacitor Cst may be connected between the second node n2 and the third node n3. The third capacitor Cst may be initialized during the initialization period Tini and then store a threshold voltage Vth of the driving transistor M6 during the sensing period Tsam. The third capacitor Cst may store the data voltage Vdata of the pixel data compensated by the threshold voltage Vth of the driving transistor M6 during the data writing period Twr, and then maintain the gate-source voltage Vgs of the driving transistor M6 during the anode reset period Tres and the emission period Tem. A transfer rate Data DR of a data voltage Vdata is as shown in the following Equation 2. [Equation 2] $Data DR = 1 - \frac{Cst}{Cst + {C}_{{DTS}_{hold}}} , {C}_{{DTS}_{hold}} = C 2 + C 2 _ A + {C}_{{DTS}_{par}}$

Here, Cst is a capacitance value of the third capacitor Cst, and *C_{DTSₚₐᵣ}* is a parasitic capacitance connected to the third node n3. The larger a *C_{DTS_{hold}}* value is, the more completely the data voltage Vdata is transferred, resulting in less loss of the data voltage Vdata.

According to Equations 1 and 2, the display panel of the present specification according to one embodiment may improve the gate-source voltage Vgs and prevent loss of data voltage Vdata by including the first and second capacitors C2 and C2_A.

Referring to FIGS. 5 and 6, an increase in the gate-source voltage Vgs may lead to the improved luminance of the light-emitting element EL by driving the driving transistor M6 with a lower voltage or by driving the driving transistor M6 with the same voltage.

Referring to FIG. 5, a conventional gate-source voltage Vgs_1 is when the second capacitor C2_A is not configured. That is, the display panel of the present specification according to one embodiment may improve the gate-source voltage Vgs by configuring the second capacitor C2_A.

Referring to FIG. 6, a graph comparing the luminance B2 of the display panel of the present specification according to one embodiment with the luminance B1 of a conventional display panel is provided. The horizontal axis A1 of the graph is the data voltage Vdata, and the vertical axis A2 is the current of the light-emitting element EL. Referring to FIG. 6, the display panel of the present specification may achieve improved luminance even with the same data voltage Vdata compared to the conventional panel.

The first switch transistor M1 may be connected between the third driving voltage node PL3 to which the reference voltage Vref is applied and the second node n2 and may be turned on in response to the gate-on voltage VGH of the second scan signal SCAN2. When the first switch transistor M1 is turned on, the reference voltage Vref may be applied to the second node n2. The first switch transistor M1 may be in an off state when a voltage of the second scan signal SCAN2 is the gate-off voltage VGL. The first switch transistor M1 may include a first electrode connected to the third driving voltage node PL3, a gate electrode connected to a gate line to which the second scan signal SCAN2 is applied, and a second electrode connected to the second node n2.

The second switch transistor M2 may be connected between the fourth driving voltage node PL4 to which the anode reset voltage Vint is applied and the fourth node n4, and may be turned on in response to the gate-on voltage VGH of the third scan signal SCAN3. When the second switch transistor M2 is turned on, the anode reset voltage Vint may be applied to the fourth node n4. The second switch transistor M2 may be in an off state when the voltage of the third scan signal SCAN3 is the gate off voltage VGL. The second switch transistor M2 may include a first electrode connected to the fourth driving voltage node PL4, a gate electrode connected to a gate line to which the third scan signal SCAN3 is applied, and a second electrode connected to the fourth node n4.

The third switch transistor M3 may be connected between the data line DL to which the data voltage Vdata of the pixel data is applied and the second node n2 and may be turned on in response to the gate-on voltage VGH of the first scan signal SCAN1. When the third switch transistor M3 is turned on, the data voltage Vdata is applied to the second node n2. The third switch transistor M3 may be in an off state when a voltage of the first scan signal SCAN1 is the gate-off voltage VGL. The third switch transistor M3 may include a first electrode connected to the data line DL, a gate electrode connected to a gate line to which the first scan signal SCAN1 is applied, and a second electrode connected to the second node n2.

The fourth switch transistor M4 may be connected between the first driving voltage node PL1 to which the pixel driving voltage EVDD is applied and the first node n1 and may be turned on in response to the gate-on voltage VGH of the first EM signal EM1. When the fourth switch transistor M4 is turned on, the pixel driving voltage EVDD may be applied to the first node n1. The fourth switch transistor M4 may include a first electrode connected to the first driving voltage node PL1, a gate electrode connected to a gate line to which the first EM signal EM1 is applied, and a second electrode connected to the first node n1.

The fifth switch transistor M5 may be connected between the third node n3 and the fourth node n4 and turned on in response to the gate-on voltage VGH of the second EM signal EM2. When the fifth switch transistor M5 is turned on, the third node n3 may be electrically connected to the fourth node n4. The fifth switch transistor M5 may include a first electrode connected to the third node n3, a gate electrode connected to a gate line to which the second EM signal EM2 is applied, and a second electrode connected to a fourth node n4.

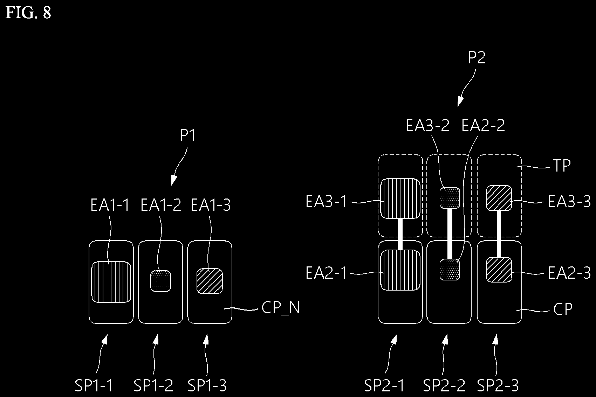

FIG. 7 is a plan view showing a first display region and a second display region according to one embodiment of the present specification. FIG. 8 is an enlarged view of a first pixel and a second pixel of FIG. 7.

Referring to FIGS. 7 and 8, the display panel may include a first display region DA including a plurality of first pixels P1 and a second display region CA including a plurality of second pixels P2. The plurality of second pixels P2 may further include light-transmitting regions TP as compared with the plurality of first pixels P1. Accordingly, the second display region CA may have higher light transmittance than the first display region DA.

The first display region DA may include the plurality of first pixels P1. Each of the first pixels P1 may include at least one subpixel. Each of the first pixels P1 according to one embodiment may include a 1-1 subpixel SP1-1, a 1-2 subpixel SP1-2, and a 1-3 subpixel SP1-3, the number of subpixels included in the first pixel in the present specification is not limited thereto.

Each of the 1-1 to 1-3 subpixels SP1-1, SP1-2, and SP1-3 may include a first pixel region CP_N. The first pixel region CP_N may include a pixel circuit for driving a pixel. In the drawing, the first pixel region CP_N represents an arbitrary region containing a pixel circuit. Each first pixel region CP_N may include a first light-emitting region EA1. The first light-emitting region EA1 may be a region from which light of a light-emitting element driven by the pixel circuit is emitted. In the drawing, the first light-emitting region EA1 represents an arbitrary region from which light is emitted.

Each of the 1-1 to 1-3 subpixels SP1-1, SP1-2, and SP1-3 may include the first light-emitting region EA1. The 1-1 subpixel SP1-1 may include a 1-1 light-emitting region EA1-1, the 1-2 subpixel SP1-2 may include a 1-2 light-emitting region EA1-2, and the 1-3 subpixel SP1-3 may include a 1-3 light-emitting region EA1-3. The light-emitting regions EA1-1, EA1-2, and EA1-3 may emit different colors and have different sizes, but the present specification is not limited thereto.

For example, the 1-1 subpixel SP1-1 may be a blue subpixel including a blue light-emitting region, the 1-2 subpixel SP1-2 may be a green subpixel including a green light-emitting region, and the 1-3 subpixel SP1-3 may be a red subpixel including a red light-emitting region. For example, the largest light-emitting region among the 1-1 to 1-3 light-emitting regions EA1-1, EA1-2, and EA1-3 may be included in the 1-1 subpixel SP1-1 and the smallest light-emitting region among the 1-1 to 1-3 light-emitting regions EA1-1, EA1-2, and EA1-3 may be included in the 1-2 subpixel SP1-2.

The second display region CA may include the plurality of second pixels P2. Each of the second pixels P2 may include at least one subpixel. Each of the second pixels according to one embodiment may include a 2-1 subpixel SP2-1, a 2-2 subpixel SP2-2, and a 2-3 subpixel SP2-3, the number of subpixels included in the second pixel in the present specification is not limited thereto.

Each of the 2-1 to 2-3 subpixels SP2-1, SP2-2, and SP2-3 may include a second pixel region CP, a light-transmitting region TP, and a connecting portion CL electrically connecting the second pixel region CP and the light-transmitting region TP. The light-transmitting region TP may emit light from the light-emitting element when the second display region CA is implemented in display mode and allow a sensor to receive external light when the second display region CA is implemented in capturing mode.

In the second pixel P2 according to one embodiment, most of the pixel circuit except for the capacitor may be disposed in the second pixel region CP. By arranging most of the pixel circuit of the second pixel P2 in the second pixel region CP, the light transmittance of the light-transmitting region TP may be higher than that of the second pixel region CP
A portion of the pixel circuit may be disposed in the light-transmitting region TP. According to one embodiment, the display panel of the present specification may include a portion of a capacitor or at least one of a plurality of capacitors of the pixel circuit in the light-transmitting region TP. That is, the second pixel region CP and the light-transmitting region TP may share a capacitor. Accordingly, the display panel of the present specification may improve the capacitance of the light-emitting elements disposed in the second and third light-emitting regions EA2 and EA3 of the second pixel P2, thereby improving the luminance of the second display region CA.

Each second pixel region CP may include the second light-emitting region EA2, and each light-transmitting region TP may include the third light-emitting region EA3. The display panel of the present specification may include a light-emitting element in the third light-emitting region EA3 in the light-transmitting region TP, thereby improving the resolution and luminance of the second display region CA compared to a case in which the light-emitting element is not included in the light-transmitting region TP, and improving the lifetime of the light-emitting element disposed in the second display region CA.

The second and third light-emitting regions EA2 and EA3 contained in one subpixel may emit light together due to the same pixel circuit. The second and third light-emitting regions EA2 and EA3 included in one subpixel may emit the same light and may have the same size, but the present specification is not limited thereto. For example, the second and third light-emitting regions EA2 and EA3 included in one subpixel may have the different size. The 2-1 subpixel SP2-1 may include 2-1 and 3-1 light-emitting regions EA2-1 and EA3-1, the 2-2 subpixel SP2-2 may include 2-2 and 3-2 light-emitting regions EA2-2 and EA3-2, and the 2-3 subpixel SP2-3 may include 2-3 and 3-3 light-emitting regions EA2-3 and EA3-3.

For example, the 2-1 and 3-1 light-emitting regions EA2-1 and EA3-1 may be regions that emit blue light, the 2-2 and 3-2 light-emitting regions EA2-2 and EA3-2 may be regions that emit green light, and the 2-3 and 3-3 light-emitting regions EA2-3 and EA3-3 may be regions that emit red light. For example, among the 2-1 to 2-3 subpixels SP2-1, SP2-2, and SP2-3, the areas of the 2-1 and 3-1 light-emitting regions EA2-1 and EA3-1 may be the largest, and the areas of the 2-3 and 3-3 light-emitting regions EA2-3 and EA3-3 may be the smallest.

The connecting portion CL may be an electrode that electrically connects the second pixel region CP and the light-transmitting region TP. Both the second and third light-emitting regions EA2 and EA3 may emit light using the same pixel circuit due to the connecting portion CL. The connecting portion CL may include an electrode or electrode pattern extending from the second light-emitting region EA2 to the third light-emitting region EA3. For example, the connecting portion CL may include an electrode connecting the anode electrodes disposed in each of the second and third light-emitting regions EA2 and EA3, a portion of the cathode electrode, a capacitor of the pixel circuit, or a partial region of the capacitor. In the following examples, the second display region CA including the connecting portion CL, the second pixel region CP, and the light-transmitting region TP will be described in detail.

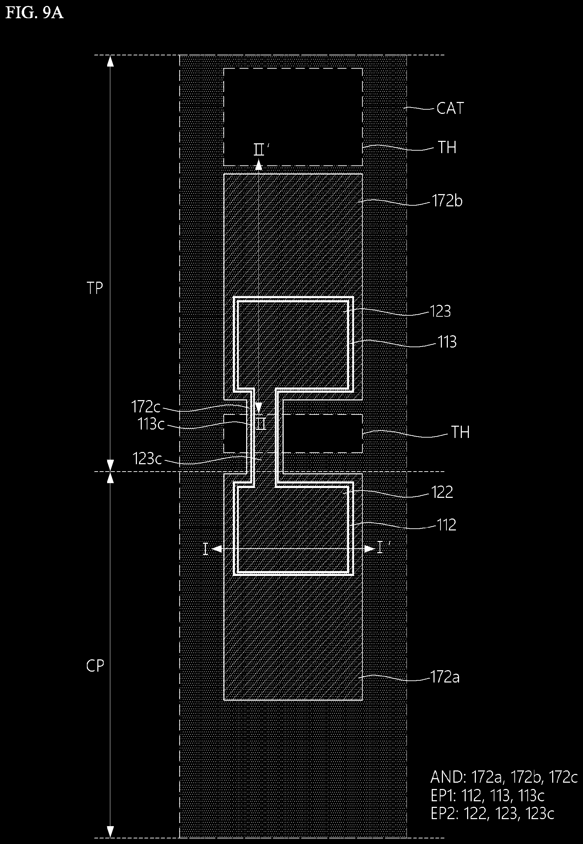

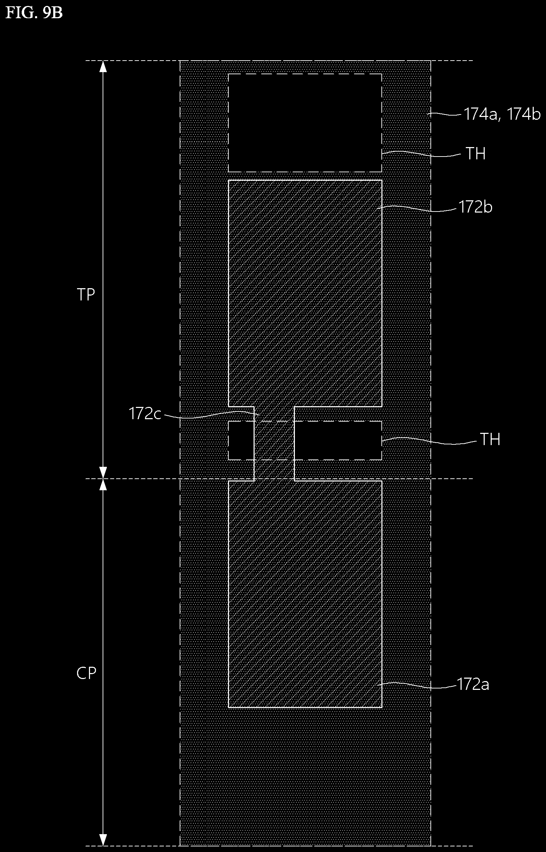

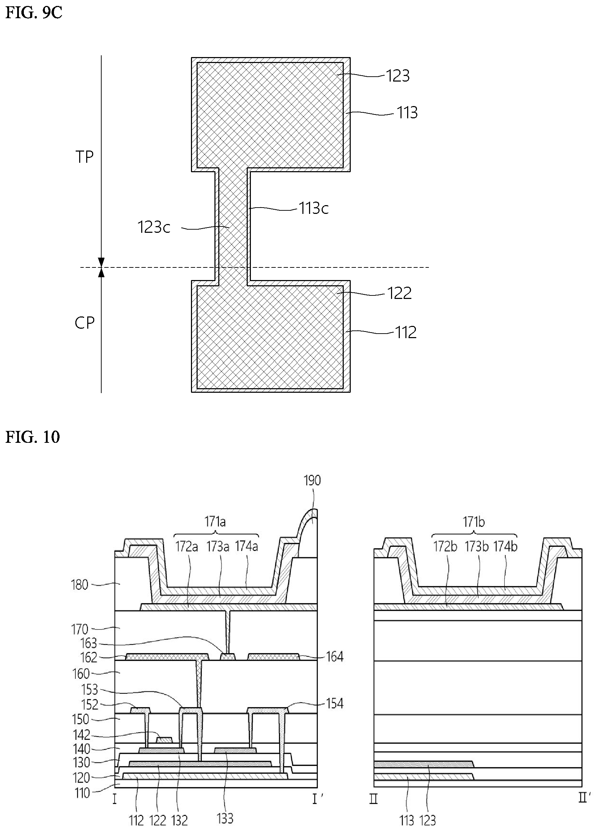

FIGS. 9A to 9C are plan views of a display panel according to a first embodiment of the present specification. FIGS. 9B and 9C are plan views each showing some components of FIG. 9A. FIG. 10 shows cross-sectional views along lines I-I' and II-II' of FIG. 9A.

Referring to FIGS. 9A to 10, a display panel according to one embodiment may include an anode electrode AND, a cathode electrode CAT, and a capacitor disposed on a second pixel region CP and a light-transmitting region TP. According to one embodiment, the capacitor may be formed in a form shared between the second pixel region CP and the light-transmitting region TP.

An anode electrode AND may include a first anode electrode region 172a, a second anode electrode region 172b, and a third anode electrode region 172c disposed between the first anode electrode region 172a and the second anode electrode region 172b. The first to third anode electrode regions 172a, 172b, and 172c according to the first embodiment may be integrally formed.

The first anode electrode region 172a may be disposed in the second pixel region CP to form a first light-emitting element 171a. The second anode electrode region 172b may be disposed in the light-transmitting region TP to form a second light-emitting element 171b. The second anode electrode region 172b may have the same area as the first anode electrode region 172a to adjust the luminance of the second display region CA to the same level as that of the first display region DA, but the present specification is not limited thereto.

The third anode electrode region 172c may connect the first and second anode electrode regions 172a and 172b. The third anode electrode region 172c may overlap a light-transmitting hole TH of the cathode electrode. Additionally, the third anode electrode region 172c may not overlap the third light-emitting region EA3 where the light of the light-emitting element is emitted.

The third anode electrode region 172c is intended to electrically connect the first and second anode electrode regions 172a and 172b and may be disposed in the light-transmitting region TP with a minimal area. Therefore, the third anode electrode region 172c may have a smaller area than the first and second anode electrode regions 172a and 172b. For example, a length of the third anode electrode region 172c in the horizontal direction (X-axis direction) may be smaller than a length of each of the first and second anode electrode regions 172a and 172b in the horizontal direction (X-axis direction).

Meanwhile, in the first display region DA, the anode electrode may be disposed in each subpixel.

For example, the anode electrode AND may include a material with a higher reflective efficiency than the cathode electrode. For example, the anode electrode AND may be formed in a multilayer structure including a transparent conductive film and an opaque conductive film with high reflection efficiency.

The cathode electrode CAT may be disposed on the anode electrode AND to face the anode electrode AND. The cathode electrode CAT may be formed on the entire surfaces of the first and second display regions DA and CA. The cathode electrode CAT may include a first cathode electrode region 174a and a second cathode electrode region 174b. The first cathode electrode region 174a may be disposed in the second pixel region CP to form a first light-emitting element 171a. The second cathode electrode region 174b may be disposed in the light-transmitting region TP to form a second light-emitting element 171b.

The cathode electrode CAT may include the light-transmitting hole TH disposed in the light-transmitting region TP. The light-transmitting hole TH is a region where the cathode electrode is not formed. Accordingly, the light transmittance of the light-transmitting region TP may be improved by the light-transmitting hole TH of the second cathode electrode region 174b. The light-transmitting hole TH may be included in the second cathode electrode region 174b. The light-transmitting hole TH may not overlap at least the light-emitting region of the second light-emitting element 171b, but the present specification is not limited thereto
The light-transmitting hole TH may be formed in a portion of the light-transmitting region TP which is exposed by the anode electrode AND, i.e. where the anode electrode AND is not formed, or which is exposed at least by the first and second anode electrode regions 172a and 172b. For example, the light-transmitting hole TH may be formed at each of upper and lower portions of the second anode electrode region 172b in the vertical direction Y. However, the light-transmitting hole TH of the present specification is not limited thereto, and in a plan view, may be formed in any region where no electrode is disposed in the light-transmitting region TP, or anywhere in the light-transmitting region TP except for the light-emitting region.

For example, the cathode electrode CAT may be formed of a conductive layer made of a transparent material. For example, the cathode electrode CAT may include indium tin oxide (ITO) or indium zinc oxide (IZO) as the conductive layer made of a transparent material, but the present specification is not limited thereto.

Meanwhile, an intermediate layer may be disposed between the anode electrode AND and the cathode electrode CAT. The intermediate layer may be formed on the entire substrate. For example, the intermediate layer may refer to a single stack or plurality of stacks of organic layers formed as a multilayer including a hole injection layer (HIL), a hole transport layer (HTL), an emission layer (EML), an electron transport layer (ETL), and an electron injection layer (EIL). The drawing shows only a first emission layer 173a of the first light-emitting element 171a and a second emission layer 173b of the second light-emitting element 171b which are portions of the intermediate layer.

The capacitor according to the first embodiment may include a first electrode pattern EP1 and a second electrode pattern EP2 that opposite to each other with an insulating layer disposed therebetween. Referring to FIG. 4, the capacitor according to the first embodiment may be a form in which the first and second capacitors C2 and C2_A are integrally shared, and one electrode layer may be extend from the second pixel region CP to the light-transmitting region TP.

The first and second electrode patterns EP1 and EP2 may function as light-blocking patterns in the second pixel region CP. The first electrode pattern EP1 may be disposed on a substrate 110, and the second electrode pattern EP2 may be disposed on a first insulating layer 120. Accordingly, the capacitor may include the first electrode pattern EP1 and the second electrode pattern EP2 formed with the first insulating layer 120 disposed therebetween. For example, the first and second electrode patterns EP1 and EP2 may include the same material, and may be formed as a single layer made of a metal material such as molybdenum (Mo), titanium (Ti), aluminum-neodymium (AlNd), aluminum (Al), or chromium (Cr), or an alloy thereof, or may be formed in a multilayer structure using these materials, but the present specification is not limited thereto.

Each of the first and second electrode patterns EP1 and EP2 may be integrally configured on the second pixel region CP and the light-transmitting region TP. The first electrode pattern EP1 may include a 1-1 region 112, a 1-2 region 113, and a 1-3 region 113c disposed between the 1-1 and 1-2 regions 112 and 113 and may be formed as a single pattern. The second electrode pattern EP2 may include a 2-1 region 122, a 2-2 region 123, and a 2-3 region 123c disposed between the 2-1 and 2-2 regions 122 and 123 and may be formed as a single pattern.

The first and second electrode patterns EP1 and EP2 may have similar shapes or similar areas in the light-transmitting region TP, but the present specification is not limited thereto. That is, the 1-2 region 113 may overlap the 2-2 region 123, and the 1-3 region 113c may overlap the 2-3 region 123c. The area of each of the 1-3 region 113c and the 2-3 region 123c may be smaller than the area of each of the 1-1 region 112, the 2-1 region 122, the 1-2 region 113, and the 2-2 region 123.

The first and second electrode patterns EP1 and EP2 may be disposed to minimize the blocking of light passing through the light-transmitting region TP. The respective 1-2 and 2-2 regions 113 and 123 of the first and second electrode patterns EP1 and EP2 may overlap in the second anode electrode region 172b. However, the display panel of the present specification is not necessarily limited thereto, and in some cases, the first and second electrode patterns EP1 and EP2 may have a larger area in the light-transmitting region TP than the anode electrode AND, according to the set capacitance value of the first capacitor C2. In the display panel according to the first embodiment, when the areas of the 1-1 and 2-1 regions 112 and 122 are fixed, a capacitance value of the first capacitor C2 in FIG. 4 may vary according to an overlapping area of the 1-2 and 2-2 regions 113 and 123.

According to the first embodiment, the 1-3 region 113c may connect the 1-1 and 1-2 regions 112 and 113, and the 2-3 region 123c may connect the 2-1 and 2-3 regions 122 and 123. According to the first embodiment, the respective 1-3 and 2-3 regions 113c and 123c of the first and second electrode patterns EP1 and EP2 may overlap within the third anode electrode region 172c. Therefore, the first and second electrode patterns EP1 and EP2 may be disposed to minimize the blocking of light passing through the light-transmitting region TP. The respective 1-3 and 2-3 regions 113c and 123c of the first and second electrode patterns EP1 and EP2 may function as capacitors, like other regions of the capacitor.

The 1-1 region 112 and the 2-1 region 122 may overlap the first anode electrode region 172a disposed in the second pixel region CP. Each of the 1-1 region 112 and the 2-1 region 122 disposed in the second pixel region CP may further include other patterns constituting the pixel circuit but is not limited to that shown.

Meanwhile, a plurality of insulating layers and electrodes may be disposed on the first and second electrode patterns EP1 and EP2. The first electrode pattern EP1 may be electrically connected to an upper electrode 154, and the upper electrode 154 may be an electrode connected to the first driving voltage node PL1 or the third node n3 of FIG. 4. The transistor electrically connected to the second electrode pattern EP2 may include the fourth switch transistor M4 connected to the first driving voltage node PL1 and the fifth switch transistor M5 or the driving transistor M6 connected to the third node n3 of FIG. 4. The transistor electrically connected to the second electrode pattern EP2 may include an active layer 132, a source electrode 152, and a drain electrode 153.

The first insulating layer 120 may be disposed on the first electrode pattern EP1. The first insulating layer 120 may include a contact hole through which the upper electrode 154 is in contact with the first electrode pattern EP1, and may be formed on the entire surfaces of the first and second display regions DA and CA.

A second insulating layer 130 may be disposed on the second electrode pattern EP2. The second insulating layer 130 may include a contact hole through which the upper electrode 154 is in contact with the first electrode pattern EP1, and may be formed on the entire surfaces of the first and second display regions DA and CA.

The active layer 132 and a lower electrode 133 may be disposed on the second insulating layer 130. The active layer 132 may include a source region and a drain region on opposite sides with a channel region disposed therebetween. Each of the source and drain regions may be formed of a semiconductor material doped with n-type or p-type impurities. The source or drain region of the active layer 132 and the lower electrode 133 may include the same material, but the present specification is not limited thereto.

A third insulating layer 140 can be disposed on the active layer 132 and the lower electrode 133. The third insulating layer 140 may include contact holes through which the source and drain electrodes 152 and 153 are in contact with the active layer 132, a contact hole through which the drain electrode 153 is in contact with the second electrode pattern EP2, a contact hole through which the upper electrode 154 is in contact with the lower electrode 133, and a contact hole through which the upper electrode 154 is in contact with the first electrode pattern EP1, and may be formed on the entire surfaces of the first and second display regions DA and CA.

A gate electrode 142 may be disposed on the third insulating layer 140. For example, the gate electrode 142 may be a single layer or a multilayer formed of any one of molybdenum (Mo), aluminum (Al), chromium (Cr), gold (Au), titanium (Ti), nickel (Ni), neodymium (Nd), and copper (Cu), or an alloy thereof, but the present specification is not limited thereto.

A fourth insulating layer 150 may be disposed on the gate electrode 142. The fourth insulating layer 150 may include contact holes through which the source and drain electrodes 152 and 153 are in contact with the active layer 132, a contact hole through which the drain electrode 153 is in contact with the second electrode pattern EP2, a contact hole through which the upper electrode 154 is in contact with the lower electrode 133, and a contact hole through which the upper electrode 154 is in contact with the first electrode pattern EP1, and may be formed on the entire surfaces of the first and second display regions DA and CA. For example, the first to fourth insulating layers 120, 130, 140, and 150 may include an inorganic insulating material, but the present specification is not limited thereto.

The source and drain electrodes 152 and 153, and the upper electrode 154 may be disposed on the fourth insulating layer 150. The source and drain electrodes 152 and 153, and the upper electrode 154 may be formed of the same material in the same process, but the present specification is not limited thereto. For example, the source and drain electrodes 152 and 153 and the upper electrode 154 may be formed of a metal material such as molybdenum (Mo), aluminum (Al), chromium (Cr), gold (Au), titanium (Ti), nickel (Ni), neodymium (Nd), or copper (Cu), or an alloy thereof, as a single layer, or may be formed as a multilayer structure using these materials, but the present specification is not limited thereto.

A fifth insulating layer 160 may be disposed on the source and drain electrodes 152 and 153, and the upper electrode 154. The fifth insulating layer 160 may include a contact hole through which a first electrode 162 is in contact with the drain electrode 153, and may be formed on the entire surfaces of the first and second display regions DA and CA. For example, the fifth insulating layer 160 may be referred to as a planarization layer or an overcoat layer and may be formed of a type of organic insulating film and may be formed as a single layer or a plurality of layers, but the present specification is not limited thereto.

The first electrode 162, a second electrode 163, and a third electrode 164 may be disposed on the fifth insulating layer 160. The first to third electrodes 162, 163, and 164 may be formed of the same material in the same process, but the present specification is not limited thereto. For example, first to third electrodes 162, 163, and 164 may include the same material as the source electrode 152, the drain electrode 153, and the upper electrode 154, but the present specification is not limited thereto.

A sixth insulating layer 170 may be disposed on the first to third electrodes 162, 163, and 164. The sixth insulating layer 170 may include a contact hole through which the first anode electrode region 172a of the anode electrode AND is in contact with the second electrode 163, and may be formed on the entire surfaces of the first and second display regions DA and CA. For example, the sixth insulating layer 170 may include the same material as the fifth insulating layer 160, but the present specification is not limited thereto.

The anode electrode AND, the emission layer (including 173a or 173b), and the cathode electrode CAT (including 174a or 174b) may be disposed sequentially above the sixth insulating layer 170. Additionally, a bank 180 may be disposed on the sixth insulating layer 170. The bank 180 may include openings exposing the first to third light-emitting regions EA1, EA2, and EA3.

A spacer 190 may be disposed on the bank 180. The spacer 190 may be disposed between the cathode electrode and the bank 180. The spacer 190 may prevent the sagging of the fine metal mask (FMM) during the process.

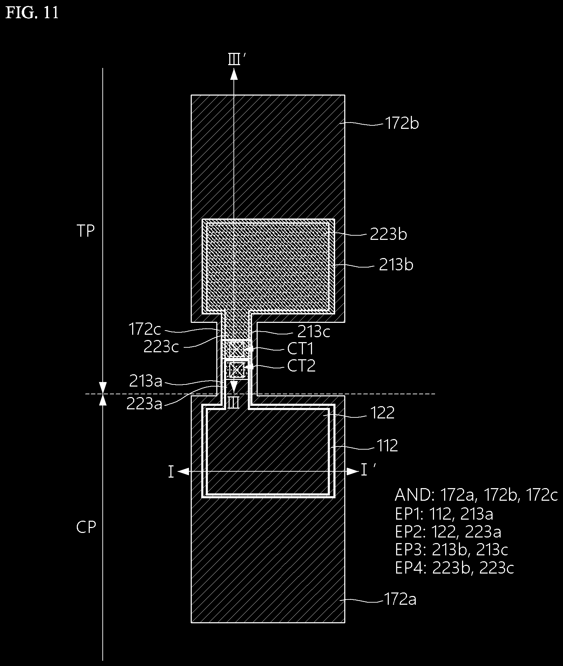

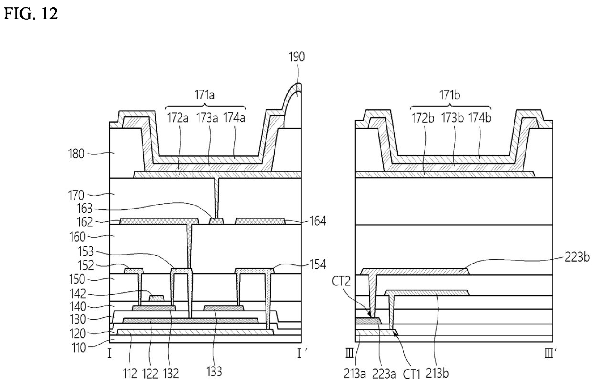

FIG. 11 is a plan view of a display panel according to a second embodiment of the present specification. FIG. 12 shows cross-sectional views along lines I-I' and III-III' of FIG. 11. Referring to FIG. 4, a capacitor according to the second embodiment may include first and second capacitors C2 and C2_A electrically connected in parallel. Hereinafter, description of the same configuration as the previous embodiment is omitted.

At least a portion of the first capacitor may be disposed in a second pixel region CP, and the second capacitor may be disposed in a light-transmitting region TP. The first capacitor may include a first electrode pattern EP1, a second electrode pattern EP2, and a first insulating layer 120 disposed between the first and second electrode patterns EP1 and EP2. The second capacitor may include a third electrode pattern EP3, a fourth electrode pattern EP4, and a fourth insulating layer 150 disposed between the third and fourth electrode patterns EP3 and EP4. The first electrode pattern EP1 may be electrically connected to the third electrode pattern EP3 through a first contact portion CT1, and the second electrode pattern EP2 may be electrically connected to the fourth electrode pattern EP4 through a second contact portion CT2.

The first electrode pattern EP1 according to the second embodiment may include a 1-1 region 112 and a first protruding pattern 213a. The second electrode pattern EP2 according to the second embodiment may include a 2-1 region 122 and a second protruding pattern 223a. The 1-1 and 2-1 regions 112 and 122 may be disposed in the second pixel region CP. The first and second protruding patterns 213a and 223a may protrude into the light-transmitting region TP from the 1-1 and 2-1 regions 112 and 122. The first and second protruding patterns 213a and 223a may overlap in a third anode electrode region 173c of an anode electrode AND to minimize the blocking of light passing through the light-transmitting region TP.

The first protruding pattern 213a may protrude further into the light-transmitting region TP than the second protruding pattern 223a. Since upper portions of the first and second protruding patterns 213a and 223a are in contact with different protruding patterns, the first protruding pattern 213a, which is disposed below the second protruding pattern 223a, may have a shape that protrudes further into the light-transmitting region TP than the second protruding pattern 223a. In some cases, a portion of the first and second protruding patterns 213a and 223a may be disposed in the second pixel region CP, and another portion may be disposed in the light-transmitting region TP, but the positions of the protruding patterns are not limited to those shown.

The third electrode pattern EP3 may include a 1-2 region 213b and a third protruding pattern 213c. The fourth electrode pattern EP4 may include a 2-2 region 223b and a fourth protruding pattern 223c. At least the 1-2 region 213b of the third electrode pattern EP3 and the 2-2 region 223b of the fourth electrode pattern EP4 may be disposed in the light-transmitting region TP.

The third electrode pattern EP3 according to the second embodiment may be formed of the same layer and the same material as a gate electrode 142 of the second pixel region CP. The fourth electrode pattern EP4 according to the second embodiment may be formed of the same layer and the same material as the source and drain electrodes 152 and 153 of the second pixel region CP. That is, the third electrode pattern EP3 may be coplanar with a gate electrode 142 of the transistor, and the fourth electrode pattern EP4 may be coplanar with source and drain electrodes 152 and 153 of the transistor.

The fourth protruding pattern 223c may protrude further toward the second pixel region CP than the third protruding pattern 213c. Accordingly, the third protruding pattern 213c may be in contact with the first protruding pattern 213a at the first contact portion CT1, and the fourth protruding pattern 223c may be in contact with the second protruding pattern 223a at the second contact portion CT2, thereby electrically connecting the first capacitor and the second capacitor.

The third and fourth electrode patterns EP3 and EP4 may be disposed in a second anode electrode region 172b and a third anode electrode region 172c of the anode electrode AND to minimize the blocking of light passing through the light-transmitting region TP. In the display panel according to the second embodiment, when the areas of the 1-1 and 2-1 regions 112 and 122 are fixed, the capacitance value of the second capacitor (C2_A of FIG. 4) may vary according to the overlapping area of the 1-2 and 2-2 regions 213b and 223b.

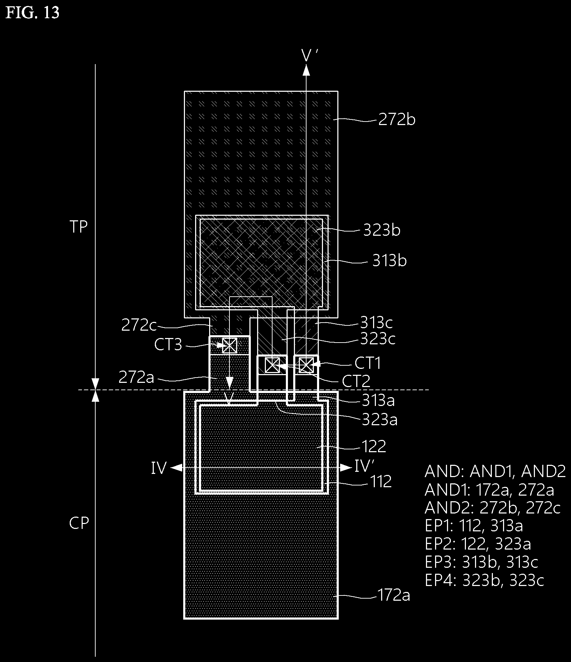

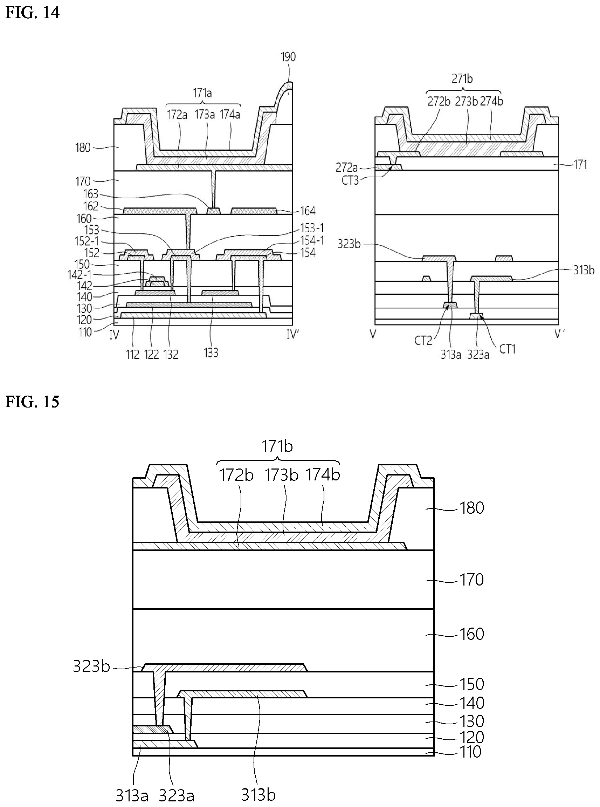

FIG. 13 is a plan view of a display panel according to a third embodiment of the present specification. FIG. 14 shows cross-sectional views along lines IV-IV' and V-V' of FIG. 13. Referring to FIG. 4, a capacitor according to the third embodiment may include first and second capacitors C2 and C2_A that are electrically connected in parallel.

An anode electrode AND according to the third embodiment may include a first anode electrode AND1 and a second anode electrode AND2, which are disposed in different layers with a seventh insulating layer 171 disposed therebetween. The first and second anode electrodes AND1 and AND2 may include different materials. The second anode electrode AND2 may include a material with lower reflection efficiency than the first anode electrode AND1. For example, the second anode electrode AND2 may be formed of a conductive layer made of a transparent material. Accordingly, first to fourth electrode patterns EP1, EP2, EP3, and EP4 according to the third embodiment may be disposed so that at least each protruding pattern does not overlap the anode electrode AND.

The first anode electrode AND1 may include a first anode electrode region 172a constituting a first light-emitting element 171a, and a fifth protruding pattern 272a protruding into a light-transmitting region TP from the first anode electrode region 172a. The fifth protruding pattern 272a may be disposed in the light-transmitting region TP, but the present specification is not limited thereto.

The second anode electrode AND2 may include a second anode electrode region 272b constituting a second light-emitting element 271b, and a sixth protruding pattern 272c protruding toward a second pixel region CP from the second anode electrode region 272b. The fifth and sixth protruding patterns 272a and 272c may overlap each other and may be in contact with each other at a third contact portion CT3 through a contact hole in the seventh insulating layer 171. Accordingly, the first and second anode electrodes AND1 and AND2 may be electrically connected.

Meanwhile, a second emission layer 273b and a cathode electrode 274b constituting the second light-emitting element 271b may be disposed on the second anode electrode AND2. The second emission layer 273b and the cathode electrode 274b may be the same as those implemented in the previous embodiment.

A first electrode pattern EP1 according to the third embodiment may include a 1-1 region 112 and a first protruding pattern 313a. A second electrode pattern EP2 according to the third embodiment may include a 2-1 region 122 and a second protruding pattern 323a. The first and second protruding patterns 313a and 323a according to the third embodiment may not overlap each other. Additionally, the first and second protruding patterns 313a and 323a according to the third embodiment may also not overlap the fifth protruding pattern 272a of the anode electrode AND.

A third electrode pattern EP3 according to the third embodiment may include a 1-2 region 313b and a third protruding pattern 313c. A fourth electrode pattern EP4 according to the third embodiment may include a 2-2 region 323b and a fourth protruding pattern 323c. In the display panel according to the third embodiment, the third and fourth electrode patterns EP3 and EP4 may be formed as electrodes made of a transparent material.

The third electrode pattern EP3 may be formed in a different process from that for forming the gate electrode 142, and the fourth electrode pattern EP4 may be formed in a process different from those for forming the source and drain electrodes 152 and 153 and the active layer 132.

In some cases, when the third electrode pattern EP3 is formed, a first transparent pattern 142-1 made of the same material as the third electrode pattern EP3 may be formed together on the gate electrode 142, and when the fourth electrode pattern EP4 is formed, second to fourth transparent patterns 152-1, 153-1, and 154-1 made of the same material as the fourth electrode pattern EP4 may be formed on upper portions of the source and drain electrodes 152 and 153 and the active layer 132, respectively. The first to fourth transparent patterns 142-1, 152-1, 153-1, and 154-1 may be formed in the second pixel region CP by using the same mask during the process of forming the third and fourth electrode patterns EP3 and EP4. However, the first to fourth transparent patterns 142-1, 152-1, 153-1, and 154-1 are not necessarily formed and may be formed optionally.

By forming the second anode electrode AND2, the third electrode pattern EP3, and the fourth electrode pattern EP4 as electrodes made of a transparent material, the display panel of the present specification may prevent a decrease in the light transmittance of the light-transmitting region TP caused by forming electrode patterns in the light-transmitting region TP. Additionally, by forming the second anode electrode AND2, the third electrode pattern EP3, and the fourth electrode pattern EP4 as electrodes made of a transparent material, the display panel of the present specification may further improve design flexibility.

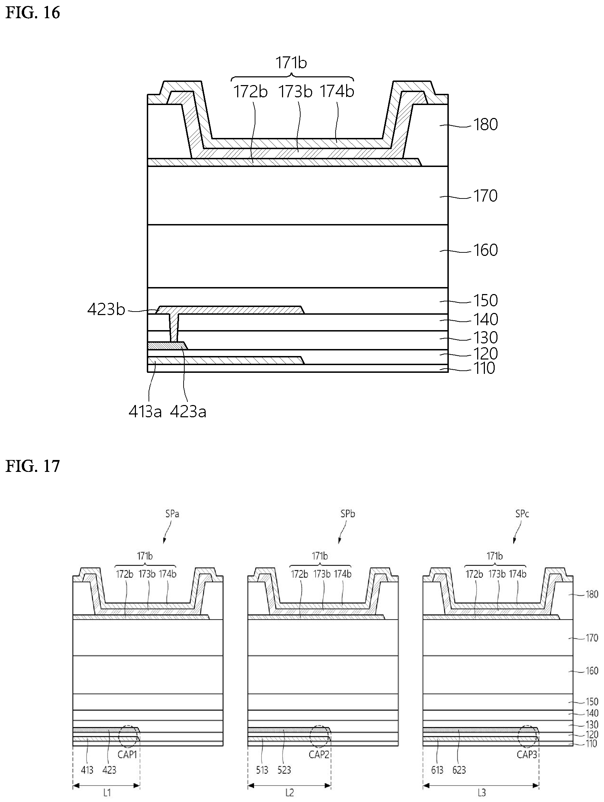

FIG. 15 is a cross-sectional view of a display panel according to a fourth embodiment of the present specification. FIG. 16 is a cross-sectional view of a display panel according to a fifth embodiment of the present specification. Referring to FIG. 4, the display panels according to the fourth and fifth embodiments show examples of adjusting the capacitance value of a second capacitor C2_A. [Equation 3] $C = \left(e\cdot A\right) / d$

In Equation 3, C is the capacitance value, e is the permittivity, A is the overlapping area between the two electrodes, and d is the distance between the two electrodes.

Referring to FIG. 4, the display panel according to the fourth embodiment shows an example of adjusting the capacitance value of the second capacitor C2_A by varying the permittivity e in Equation 3. Referring to FIG. 4, the display panel according to the fifth embodiment shows an example of adjusting the capacitance value of the second capacitor C2_A by varying the distance d between the two electrodes in Equation 3.

Referring to FIG. 15, a second anode electrode region 172b of an anode electrode may not be formed of a transparent material, whereas a third electrode pattern including a 1-2 region 313b and a fourth electrode pattern including a 2-2 region 323b may be formed of a transparent material.

Since the anode electrode is not made of a transparent material, the light transmittance of the light-transmitting region TP is lower compared to the case in which the anode electrode, the third electrode pattern, and the fourth electrode pattern are all formed of a transparent material. However, the capacitance value of the second capacitor that includes the third and fourth electrode patterns may differ compared to forming the third and fourth electrode patterns as electrodes made of an opaque material. That is, the fourth embodiment may adjust the capacitance value by changing the permittivity of the second capacitor.

Referring to FIG. 16, the display panel according to the fifth embodiment may include a first protruding pattern 413a disposed on a substrate 110, a second protruding pattern 423a disposed on a first insulating layer 120, and a fourth protruding pattern 423b disposed on a third insulating layer 140. The fourth protruding pattern 423b may be formed to be coplanar with the gate electrode of a second pixel region. The second and fourth protruding patterns 423a and 423b may be in contact with each other through contact holes disposed in a second insulating layer 130 and the third insulating layer 140. Alternatively, instead of the second insulating layer 130 and the third insulating layer 140, one insulating layer may be formed between the second and fourth protruding patterns 423a and 423b. In the fifth embodiment, the first and third electrode patterns EP1 and EP3 may be integrally formed, the second and fourth electrode patterns EP2 and EP4 may be electrically connected, and the insulating layers disposed between the third and fourth electrode patterns EP3 and EP4 may include the first insulating layer 120 and another insulating layer.

Since the first to third insulating layers 120, 130, and 140 are disposed between the first and fourth protruding patterns 413a and 423b, the capacitance value of the second capacitor may be lower than when only one insulating layer is disposed. That is, the fifth embodiment may adjust the capacitance value by varying the distance between the second and fourth protruding patterns 423a and 423b of the second capacitor.

FIG. 17 is a cross-sectional view of the first to third subpixels SPa, SPb, and SPc included in a second pixel (P2 in FIG. 8) according to a sixth embodiment of the present specification. At least one subpixel of a plurality of first to third subpixels SPa, SPb, and SPc of the second pixel according to the sixth embodiment may have a different capacitance value.

Referring to FIG. 17, the first subpixel SPa may include a 1-1a region 413 of a first electrode pattern and a 1-2a region 423 of a second electrode pattern, which overlap by a first area L1, the second subpixel SPb may include a 1-1b region 513 of a first electrode pattern and a 1-2b region 523 of a second electrode pattern, which overlap by a second area L2, and the third subpixel SPc may include a 1-1c region 613 of a first electrode pattern and a 1-2c region 623 of a second electrode pattern, which overlap by a third area L3. The first to third areas L1, L2, and L3 may be different from each other. The second area L2 may be larger than the first area L1, and the third area L3 may be larger than the second area L2.

The region between the 1-1a region 413 and the 1-2a region 423 may have a first capacitance CAP1, the region between the 1-1b region 513 and the 1-2b region 523 may have a second capacitance CAP2, and the region between the 1-1c region 613 and the 1-2c region 623 may have a third capacitance CAP3. The first to third capacitances CAP1, CAP2, and CAP3 may have different values. According to the first to third areas L1, L2, and L3, the second capacitance CAP2 may be greater than the first capacitance CAP1, and the third capacitance CAP3 may be greater than the second capacitance CAP2.

Accordingly, the first to third subpixels SPa, SPb, and SPc included in one second pixel may implement different capacitance values corresponding to light-emitting elements that emit different colors by varying the overlapping areas of the second capacitor. For example, the first subpixel SPa may be a green subpixel, the second subpixel SPb may be a red subpixel, and the third subpixel SPc may be a blue subpixel, but the present specification is not limited thereto.

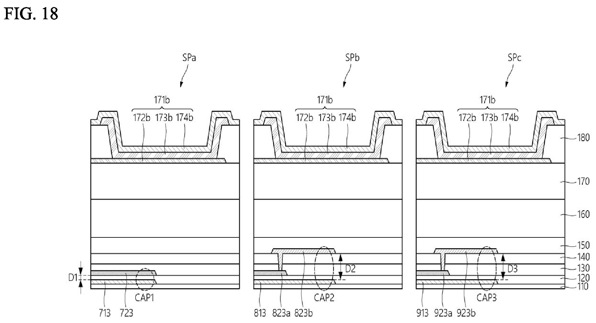

FIG. 18 is a cross-sectional view of first to third subpixels SPa, SPb, and SPc included in a second pixel (P2 in FIG. 8) according to a seventh embodiment of the present specification. According to the seventh embodiment, at least one subpixel among the plurality of first to third subpixels SPa, SPb, and SPc of the second pixel may have a different capacitance value.

Referring to FIG. 18, the first subpixel SPa may include a 1-1a region 713 of a first electrode pattern and a 1-2a region 723 of a second electrode pattern which are spaced a first distance D1 apart from each other. The second sub-pixel SPb may include a 1-1b region 813 of a first electrode pattern, a 1-2b region 823a of a second electrode pattern, and a 1-3b region 823b of a third electrode pattern. The 1-1b region 813 of a first electrode pattern and the 1-3b region 823b of a third electrode pattern may be spaced apart from each other a second distance D2. The third sub-pixel SPc may include a 1-1c region 913 of a first electrode pattern, a 1-2c region 923a of a second electrode pattern, and a 1-3c region 923b of a third electrode pattern. The 1-1c region 913 of a first electrode pattern and the 1-3c region 923b of a third electrode pattern may be spaced apart from each other a third distance D3. The second distance D2 may be greater than the first distance D1, and the third distance D3 may be the same as the second distance D2.

The region between the 1-1a region 713 and the 1-2a region 723 may have a first capacitance CAP1, the region between the 1-1b region 813 and the 1-3b region 823b may have a second capacitance CAP2, and the region between the 1-1c region 913 and the 1-3c region 923b may have a third capacitance CAP3. According to the first to third distances D1, D2, and D3, the second capacitance CAP2 may be greater than the first capacitance CAP1, and the third capacitance CAP3 may be the same as the second capacitance CAP2.

Accordingly, the first to third subpixels SPa, SPb, and SPc included in one second pixel may implement different capacitance values corresponding to light-emitting elements that emit different colors by varying the separation distances of the second capacitor. For example, the first subpixel SPa may be a blue subpixel, the second subpixel SPb may be a red subpixel, and the third subpixel SPc may be a green subpixel, but the present specification is not limited thereto.

The embodiments implemented above may be selectively implemented for each subpixel according to the electrical characteristics of the subpixels, and thus the capacitance values of the subpixels may be formed to be different from one another.

In the following, preferred aspects and embodiments of the present invention are described:
According to an aspect, a display panel according to one embodiment of the present specification includes a first display region including a first pixel region and a light-transmitting region, wherein the first pixel region and the light-transmitting region share a capacitor.

According to an aspect, a display panel includes a first display region including a plurality of first pixels, and a second display region including a plurality of second pixels, wherein the plurality of first pixels respectively includes a first pixel region and a light-transmitting region. The first pixel region and the light-transmitting region may share a capacitor.

According to an aspect of the present invention, a display panel includes a pixel circuit according to any one of the herein described aspects and embodiments; a first pixel region and a light-transmitting region; and a first pixel in which the pixel circuit is disposed, wherein the second capacitor is disposed in the light-transmitting region.

According to an aspect of the present invention, a display panel includes a pixel circuit according to any one of the herein described aspects and embodiments; a first pixel region and a light-transmitting region; and a first pixel in which a pixel circuit is disposed. The pixel circuit comprises a driving transistor including a first electrode connected to a first node, a gate electrode connected to a second node, and a second electrode connected to a third node; a driving voltage node to which a pixel driving voltage is applied; a first capacitor connected between the driving voltage node and the third node; and a second capacitor connected to the first capacitor; wherein the second capacitor is disposed in the light-transmitting region.

According to an aspect of the present invention, a display device includes a display panel according to any one of the herein described aspects and embodiments; and a camera module disposed in or below or corresponding to the first display region. Light may be incident through the first display region (CA), in particular through the light-transmitting regions of the first display region, into the camera module.

The display panel according to any one of these aspects may include one or more of the following features:
The first pixel region and the light-transmitting region may share the capacitor. That is, the capacitor may be disposed in the first pixel region and in the light-transmitting region. The capacitor may include a first capacitor (or first capacitor portion) disposed in the first pixel region and a second capacitor (or second capacitor portion) disposed in the light-transmitting region. The first capacitor (portion) and the second capacitor (portion) may be (electrically) connected to each other.

The capacitor, in particular the first capacitor (portion), may be connected between a driving voltage node and an electrode of a driving transistor. The driving voltage node may be connected to a pixel driving voltage supply. That is, a pixel driving voltage may be applied to the driving voltage node. Each of the first pixels may include a pixel circuit comprising the driving transistor and the capacitor.

The first capacitor (portion) and the second capacitor (portion) may be (electrically) connected to each other and/or may be integrally formed. The first capacitor and the second capacitor may commonly share a first electrode pattern and a second electrode pattern, which are facing each other with an insulating layer disposed in between. The (common) first electrode pattern of the first capacitor (portion) and the second capacitor (portion), i.e. the first electrode pattern commonly shared the first capacitor (portion) and the second capacitor (portion), may be disposed on one layer and/or may be made of the same material and/or may be disposed in the first pixel region and in the light-transmitting region. The (common) second electrode pattern of the first capacitor (portion) and the second capacitor (portion), i.e. the second electrode pattern commonly shared the first capacitor (portion) and the second capacitor (portion), may be disposed on one layer and/or may be made of the same material and/or may be disposed in the first pixel region and in the light-transmitting region.

The first capacitor (portion) and the second capacitor (portion) may be (electrically) connected to each other. The first capacitor (portion) may comprise a first electrode pattern and a second electrode pattern, which are facing each other with a first insulating layer disposed in between in the first pixel region. The second capacitor (portion) may comprise a third electrode pattern and a fourth electrode pattern, which are facing each other with a second insulating layer disposed in between in the light-transmitting region. At least one of the first electrode pattern and the second electrode pattern may be disposed in different layers and/or made of different materials than at least one of the third electrode pattern and the fourth electrode pattern. The first electrode pattern may be connected to the third electrode pattern, e.g. through a first contact portion in the first insulating layer, and/or the second electrode pattern may be connected to the fourth electrode pattern, e.g. through a second contact portion in the second insulating layer. Alternatively, the first electrode pattern may be integrally formed with the third electrode pattern and/or the second electrode pattern may be integrally formed with the fourth electrode pattern.

The first pixel region and the light-transmitting region may respectively include a light-emitting region and/or a light-emitting element.

Each of the plurality of first pixels may include a plurality of first subpixels, and each of the plurality of first subpixels may include a first pixel region and a light-transmitting region. The plurality of first subpixels may include at least a first subpixel and a second subpixel which are configured to emit in different colors. Light-emitting regions of the first and second subpixels may have different sizes. The capacitors of the first and second subpixels may have different sizes. Third and/or fourth electrode patterns of the capacitors of the first and second subpixels may have different sizes. A capacitance of the second capacitor portion of the first subpixel may have a different value from a capacitance of the second capacitor portion of the second subpixel. The second capacitor of the first subpixel may include a third insulating layer disposed between the third and fourth electrode patterns.

A first light-emitting element may be disposed in the first pixel region. A second light-emitting element may be disposed in the light-transmitting region. A pixel circuit of the corresponding first pixel may be connected to both the first and the second light-emitting element.

The capacitor may include a first electrode pattern disposed on the first pixel region and the light-transmitting region, and a second electrode pattern disposed on the first pixel region and the light-transmitting region. The second electrode pattern may be disposed opposite to or facing the first electrode pattern. The capacitor may include a first insulating layer disposed between the first and second electrode patterns.

The capacitor may include a first capacitor (portion) disposed in the first pixel region and a second capacitor (portion) disposed in the light-transmitting region. The first and second capacitors may be electrically connected.

The first capacitor may include a first electrode pattern, a second electrode pattern opposite to the first electrode pattern, and a first insulating layer disposed between the first and second electrode patterns. The second capacitor may include a third electrode pattern, a fourth electrode pattern opposite to the third electrode pattern, and a second insulating layer disposed between the third and fourth electrode patterns. The first and third electrode patterns may be electrically connected and/or integrally formed, and/or the second and fourth electrode patterns may be electrically connected and/or integrally formed.

The first and the second insulating layer may be disposed between the third and fourth electrode patterns. The first electrode pattern may further include a first protruding pattern protruding into the light-transmitting region. The second electrode pattern may further include a second protruding pattern protruding into the light-transmitting region. The third electrode pattern may further include a third protruding pattern protruding toward the first pixel region. The fourth electrode pattern may further include a fourth protruding pattern protruding toward the first pixel region. The first and third protruding patterns may be in contact with each other. The second and fourth protruding patterns may be in contact with each other.

The third and fourth electrode patterns may be made of a transparent material.

The first display region may include a first anode electrode disposed in the first pixel region, and a second anode electrode disposed in the light-transmitting region and electrically connected to the first anode electrode.

The second anode electrode may be made of a transparent material.

The second anode electrode may overlap with a region of the capacitor disposed in the light-transmitting region.

Each of the first to fourth protruding patterns may not overlap the first anode electrode and the second anode electrode.

The first display region may include a first anode electrode disposed in the first pixel region, and a second anode electrode disposed in the light-transmitting region and electrically connected to the first anode electrode. At least a region of the capacitor disposed in the light-transmitting region may be within a region of the second anode electrode.

The first pixel region may include a transistor disposed on the first capacitor (portion). The third electrode pattern may be coplanar with a gate electrode of the transistor, and/or the fourth electrode pattern may be coplanar with source and drain electrodes of the transistor. The third electrode pattern may be disposed on a same layer as a gate electrode of the transistor, and/or the fourth electrode pattern may be disposed on a same layer as source and drain electrodes of the transistor.

The first capacitor may include: a first electrode pattern, a second electrode pattern opposite to the first electrode pattern, and an insulating layer disposed between the first and second electrode patterns. The second capacitor may include a third electrode pattern, a fourth electrode pattern opposite to the third electrode pattern, and insulating layers disposed between the third and fourth electrode patterns. The insulating layer disposed between the first and second electrode patterns may include a first insulating layer. The insulating layers disposed between the third and fourth electrode patterns may include the first insulating layer and a second insulating layer.

The first and third electrode patterns may be integrally formed, and the second and fourth electrode patterns may be electrically connected.

The first display region may include a plurality of subpixels each of which includes the first pixel region and the light-transmitting region. The plurality of subpixels may include at least a first subpixel and a second subpixel that have different colors. The first subpixel may be formed such that the first electrode pattern disposed in the light-transmitting region and the second electrode pattern disposed in the light-transmitting region overlap by a first area. The second subpixel may be formed such that the first electrode pattern disposed in the light-transmitting region and the second electrode pattern disposed in the light-transmitting region overlap by a second area. The first and second areas may have different sizes.

The first display region may include a plurality of subpixels each of which includes the first pixel region and the light-transmitting region, the plurality of subpixels may include at least a first subpixel and a second subpixel that have different colors. A capacitance of the second capacitor of the first subpixel may have a different value from a capacitance of the second capacitor of the second subpixel.

The first display region may include a plurality of subpixels each of which includes the first pixel region and the light-transmitting region, the plurality of subpixels may include at least a first subpixel and a second subpixel that have different colors. The second capacitor of the first subpixel may include a third insulating layer disposed between the third and fourth electrode patterns.

The display panel may include a second display region including a second pixel region. A capacitance of a capacitor disposed in the second pixel region may be lower than a capacitance of a capacitor disposed in the first pixel region and the light-transmitting region.

The first display region may includes: a first anode electrode disposed in the first pixel region; and a second anode electrode disposed in the light-transmitting region and electrically connected to the first anode electrode. Each of the first to fourth protruding patterns may not overlap the first anode electrode and the second anode electrode.

According to one embodiment of the present specification, the first display region further includes a connecting portion that electrically connects the first pixel region and the light-transmitting region, a light-emitting region is disposed in each of the first pixel region and the light-transmitting region, and the light-emitting regions of the first pixel region and the light-transmitting region emit light together through the connecting portion.

According to one embodiment of the present specification, the display panel further includes a cathode electrode including a light-transmitting hole overlapping an area around the second anode electrode, and the first display region further includes a third anode electrode that connects the first and second anode electrodes, and the third anode electrode overlaps a light-transmitting hole of the cathode electrode.

According to an aspect of the present invention, a pixel circuit includes a driving transistor including a first electrode connected to a first node, a gate electrode connected to a second node, and a second electrode connected to a third node, a driving voltage node to which a pixel driving voltage is applied, a first capacitor connected between the driving voltage node and the third node, and a second capacitor connected to the first capacitor.

The pixel circuit may include a third capacitor connected between the second node and the third node.

According to an aspect of the present invention, a pixel circuit includes: a driving transistor including a first electrode connected to a first node, a gate electrode connected to a second node, and a second electrode connected to a third node; a driving voltage node to which a pixel driving voltage is applied; and a capacitor including a first capacitor connected between the driving voltage node and the third node and a second capacitor connected to the first capacitor.

The pixel circuit may be disposed in the first pixel, except for the second capacitor. The second capacitor may be disposed in the light-transmitting region. The first capacitor may be disposed in the pixel region.

The capacitor may be disposed in the light-transmitting region and the pixel region. Thus, the light-transmitting region and the pixel region share the capacitor.

According to one embodiment of the present specification, a first pixel region and a light-transmitting region, and a first pixel in which the pixel circuit is disposed, and the second capacitor may be disposed in the light-transmitting region.

The first pixel may include a first light-emitting element disposed in the first pixel region, and a second light-emitting element disposed in the light-transmitting region. The pixel circuit may be configured to simultaneously supply a current to the first and second light-emitting elements.

A display panel according to one embodiment of the present specification can implement a full-screen display with improved resolution and luminance of an imaging region.

The effects of the present specification are not limited to the effect described above, and other effects that are not described can be clearly understood by a person having ordinary skill in the technical field to which the technical idea of the present specification belongs from the description below.

Accordingly, the embodiments disclosed in the present disclosure are not intended to limit the technical idea of the present disclosure but illustrate it, and the scope of the technical idea of the present disclosure is not limited by these embodiments.

Accordingly, the above-described embodiments should be understood in all respects as illustrative and not restrictive.

## Claims

1. A display panel, comprising:
a first display region (CA) including a plurality of first subpixels (SP2-1, SP2-2, SP2-3), and
a second display region (DA) including a plurality of second subpixels (SP1-1, SP1-2, SP1-3),
wherein each of the plurality of first subpixels (SP2-1, SP2-2, SP2-3) includes a first pixel region (CP) and a light-transmitting region (TP),
wherein each of the plurality of first subpixels (SP2-1, SP2-2, SP2-3) includes a capacitor disposed in the first pixel region (CP) and in the light-transmitting region (TP).

2. The display panel of claim 1, wherein the capacitor includes a first capacitor portion (C2) disposed in the first pixel region (CP) and a second capacitor portion (C2_A) disposed in the light-transmitting region (TP), and
wherein the first and second capacitor portions (C2, C2_A) are electrically connected and/or integrally formed.

3. The display panel of claim 2, wherein the first capacitor portion (C2) in the first pixel region (CP) includes:
a first electrode pattern (EP1);
a second electrode pattern (EP2) opposite to the first electrode pattern (EP1); and
a first insulating layer (120) disposed between the first and second electrode patterns (EP1, EP2),
the second capacitor portion (C2_A) includes in the light-transmitting region (TP):
a third electrode pattern (EP3);
a fourth electrode pattern (EP4) opposite to the third electrode pattern (EP3); and
a second insulating layer (120, 150) disposed between the third and fourth electrode patterns (EP3, EP4),
wherein the first and third electrode patterns (EP1, EP3) are electrically connected and/or integrally formed, and
wherein the second and fourth electrode patterns (EP2, EP4) are electrically connected and/or integrally formed.

4. The display panel of claim 3, wherein the first electrode pattern (EP1) further includes a first protruding pattern (213a) protruding into the light-transmitting region (TP),
wherein the second electrode pattern (EP2) further includes a second protruding pattern (223a) protruding into the light-transmitting region (TP),
wherein the third electrode pattern (EP3) further includes a third protruding pattern (213b) protruding toward the first pixel region (CP),
wherein the fourth electrode pattern (EP4) further includes a fourth protruding pattern (223b) protruding toward the first pixel region (CP),
wherein the first and third protruding patterns (213a, 213b) are in contact with each other, and
wherein the second and fourth protruding patterns (223a, 223b) are in contact with each other.

5. The display panel of claim 3 or 4, wherein the third and fourth electrode patterns (EP3, EP4) are made of a transparent material.

6. The display panel according to any one of the preceding claims, wherein each of the plurality of first subpixels (SP2-1, SP2-2, SP2-3) includes:
a first anode electrode (AND1) disposed in the first pixel region (CP); and
a second anode electrode (AND2) disposed in the light-transmitting region (TP) and electrically connected to the first anode electrode (AND1).

7. The display panel of claim 6,
wherein the second anode electrode (AND2) is made of a transparent material; and/or
wherein at least a region of the capacitor disposed in the light-transmitting region (TP) is overlapped with the second anode electrode (AND2).

8. The display panel according to any one of the preceding claims in combination with claim 3, wherein the first pixel region (CP) further includes a transistor disposed on the first capacitor portion (C2_A),
wherein the third electrode pattern (EP3) is disposed in a same layer as a gate electrode (142) of the transistor, and/or
wherein the fourth electrode pattern (EP4) is disposed in a same layer as source and drain electrodes (152, 153) of the transistor.

9. The display panel according to any one of the preceding claims in combination with claim 3, wherein the plurality of first subpixels (SP2-1, SP2-2, SP2-3) includes at least a first subpixel (SP2-1) and a second subpixel (SP2-2) which are configured to emit in different colors, and:
wherein in the first subpixel (SP2-1), the third electrode pattern (EP3) and the fourth electrode pattern (EP4) overlap by a first area, and in the second subpixel (SP2-2), the third electrode pattern (EP3) and the fourth electrode pattern (EP4) overlap by a second area, and the first and second areas have different sizes; and/or
wherein a capacitance of the second capacitor (C2) of the first subpixel (SP2_1) has a different value from a capacitance of the second capacitor (C2_A) of the second subpixel (SP2-2).

10. The display panel according to any one of the preceding claims, wherein each of the plurality of second subpixels (SP1-1, SP1-2, SP1-3) in the second pixel region (DA) includes a capacitor having a capacitance that is lower than a capacitance of the capacitor of each of the plurality of first subpixels (SP2-1, SP2-2, SP2-3).

11. The display panel according to any one of the preceding claims in combination with claims 4 and 6, wherein each of the first to fourth protruding patterns (213a, 223a, 213b, 223b) does not overlap the first anode electrode (AND1) and the second anode electrode (AND2).

12. The display panel according to any one of the preceding claims, wherein each of the plurality of the first subpixels (SP2-1, SP2-2, SP2-3) includes:
a first light-emitting element (171a) disposed in the first pixel region (CP); and
a second light-emitting element (171b) disposed in the light-transmitting region (TP),
wherein a connecting portion (CL) electrically connects the first light-emitting element (171a) and the second light-emitting element (171b) so that the first light-emitting element (171a) and the second light-emitting element (171b) emit light together.

13. The display panel according to any one of the preceding claims in combination with claim 6, wherein each of the plurality of first subpixels (SP2-1, SP2-2, SP2-3) includes:
a cathode electrode (CAT) including a light-transmitting hole (TH) disposed between the first anode electrode (AND1) and the second anode electrode (AND2),
a third anode electrode (AND3) that connects the first and second anode electrodes (AND1, AND2), and
wherein the third anode electrode (AND3) overlaps a light-transmitting hole (TH) of the cathode electrode (CAT).

14. The display panel according to any one of the preceding claims, wherein a pixel circuit is disposed in each of the plurality of first subpixels (SP2-1, SP2-2, SP2-3), the pixel circuit comprising:
a driving transistor (M6) including a first electrode connected to a first node (n1), a gate electrode connected to a second node (n2), and a second electrode connected to a third node (n3);
a driving voltage node (PL1) to which a pixel driving voltage (EVDD) is applied; and
a capacitor including a first capacitor portion (C2) connected between the driving voltage node (PL1) and the third node (n3), and a second capacitor portion (C2_A) connected to the first capacitor portion (C2);
wherein the second capacitor portion (C2_A) is disposed in the light-transmitting region (TP).

15. The display panel of claim 14, wherein each of the plurality of the first subpixels (SP2-1, SP2-2, SP2-3) includes:
a first light-emitting element (171a) disposed in the first pixel region (CP); and
a second light-emitting element (17b) disposed in the light-transmitting region (TP),
wherein the pixel circuit of the respective first subpixel (SP2-1, SP2-2, SP2-3) is connected to the first light-emitting element (171a) and to the second light-emitting element (171b).
